(19) Europäisches Patentamt
European Patent Office
Office européen des brevets

(11) EP 1 610 191 A1

(12) **EUROPEAN PATENT APPLICATION**
published in accordance with Art. 158(3) EPC

(43) Date of publication:
**28.12.2005 Bulletin 2005/52**

(21) Application number: **04721695.7**

(22) Date of filing: **18.03.2004**

(51) Int Cl.[7]: **G03H 1/02**, G03H 1/04, G03F 7/004

(86) International application number:
**PCT/JP2004/003684**

(87) International publication number:
**WO 2004/086151 (07.10.2004 Gazette 2004/41)**

(84) Designated Contracting States:
**AT BE BG CH CY CZ DE DK EE ES FI FR GB GR HU IE IT LI LU MC NL PL PT RO SE SI SK TR**
Designated Extension States:
**AL LT LV MK**

(30) Priority: **24.03.2003 JP 2003079523**

(71) Applicant: **Konica Minolta Medical & Graphic Inc.**
**Tokyo 163-9512 (JP)**

(72) Inventor: **TAKEYAMA, Toshihisa**
**Hino-shi Tokyo 191-8511 (JP)**

(74) Representative: **Murphy, Colm Damien et al**
**Urquhart-Dykes & Lord LLP,**
**30 Welbeck Street**
**London W1G 8ER (GB)**

# (54) HOLOGRAPHIC RECORDING MEDIUM AND RECORDING METHOD THEREFOR

(57) A holographic recording medium comprising a first substrate and a second substrate having a holographic recording layer between the first substrate and the second substrate, the holographic recording layer containing:

(A) a binder compound having a reactive group;
(B) a polymerizable compound having an ethylenic double bond;
(C) a photoinitiator; and
(D) a cross-linking agent which reacts with the reactive group in the binder compound,

wherein the photoinitiator contains a compound represented by Formula (1):

Formula (1)

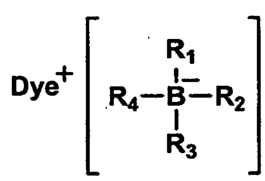

wherein $Dye^+$ is a cationic dye, each $R^1$ to $R^4$ is independently a substituted or unsubstituted alkyl, aryl, aralkyl, alkenyl, alkynyl, heterocylic group or a cyano group, provided that two or more of $R^1$ to $R^4$ can form a ring.

EP 1 610 191 A1

## Description

### TECHNICAL FIELD

The present invention relates to a holographic recording medium capable of providing a large amount of capacity as well as a holographic recording composition and a holographic recording method suitable for said medium.

### BACKGROUND

In recent years, data access at high speed and of large capacity has been increasing due to popularization or broadening-band of inter-net, and volume of the data stored at each belonging organization has been rapidly increasing due to expansion of an electronic government promoted by the government of every nation. Further, a recording medium having a large memory capacity is supposed to be required hereafter because of popularization of Hi-Vision in TV broadcasting and of earthly wave digital broadcasting, and, in this situation, photo-recording media of a new generation such as a Blue-ray disc are expected to prevail. However, as for recording media of the second next generation, various types of methods having been proposed not to determine a leading candidate till now.

Among the recording media of the second next generation, memory system of a paging-style, specifically, holographic recording has been proposed as a substitute to conventional memory devices, and is attracting notice recently because it is a method provided with a high memory capacity and random access capability. This holographic recording is detailed in several introductions (for example, refer to non-patent literature 1).

There are proposed such as a recording method (for example, refer to patent literature 1) employing a holographic recording medium in which transparent substrates are arranged on the both sides of a holographic recording layer, and a recording medium (for example, refer to patent literature 2) employing a holographic recording medium provided with a reflection plane arranged on the one side of a holographic recording layer. In these recording media, a holographic recording layer can be said to be a key technique to control the capabilities.

Such a holographic recording layer employs a basic principle to record information by changing the refractive index of the inside of the layer by holographic exposure and regenerate the information by reading out the change of the refractive index in the recorded medium, and proposed as the holographic recording layer are various types such as materials utilizing inorganic materials (for example, refer to patent literature 3), materials utilizing compounds which structurally isomerize with light (for example, refer to patent literature 4) or materials utilizing diffusion polymerization of photopolymers (for example, refer to patent literature 5). Among them, in the materials utilizing photopolymers described in patent literature 5, the thickness of the material is restricted up to approximately 150 µm, since a volatile solvent is employed at the preparation of the recording layer forming composition. Further, volume shrinkage of 4 - 10% caused by polymerization has badly effected the reliability at the time of regenerating the recorded information.

To overcome the aforesaid disadvantages, proposed is such as a holographic recording layer forming composition (for example, refer to patent literature 6), which employs cationic polymerization which utilizing no solvent and exhibits a relatively small volume shrinkage. However, since components other than the monomer which causes cationic photo-polymerization, are liquid substances in this recording layer forming composition, there was a fear that the island-form portions having been formed by photo-polymerization of the monomer in the recording layer with holographic exposure may migrate, or a problem that the liquid substances may expand due to ambient temperature change in the apparatus. Therefore, there is proposed such as a composition (for example, refer to patent literature 7) in which radical polymerization is employed for recording at holographic exposure and a binder matrix is formed after the media formation to retain the monomer capable of radical polymerization before the exposure. By utilizing this composition, the thickness of a holographic recording layer can be made heavy, and the volume shrinkage is small to enhance the reliability of the information obtained at the time of reproduction.

On the other hand, in the case of performing holographic recording on a holographic recording medium, it is indispensable to be able to expose at a lower energy to increase the recording speed. To increase the recording speed, in other words, the recording sensitivity, important are the selection and combination of a radical polymerizable monomer, a binder matrix, a sensitizing dye and a radical initiator. For example, there is proposed such as a specific combination of a sensitizing dye and a radical generator (for example, refer to patent literature 8), however it cannot be said satisfactory yet.

[Patent literature 1] USP No. 5,719,691

[Patent literature 2] JP-A No. 2002-123949

(Hereinafter, JP-A refers to Japanese Patent Publication Open to Public Inspection)

[Patent literature 3] British Patent No. 9,929,953

[Patent literature 4] JP-A No. 10-340479

[Patent literature 5] USP No. 4,942,112

[Patent literature 6] USP No. 5,759,721

[Patent literature 7] USP No. 6,482,551
[Patent literature 8] JP-A No. 6-130880
[Non-patent literature 1]

Hans J. Coufal, et. al. "Holographic Data Storage (Springer Series in Optical Sciences, Vol. 76)", Springer-Verlag GmbH & Co. KG, (Aug. 2002)

This invention has been made in view of the above-described problems, and an object of the invention is to provide holographic recording media having a high sensitivity and a holographic recording method employing them.

## DISCLOSURE OF THE INVENTION

The aforesaid objective of this invention has been achieved by the following embodiments.

1. A holographic recording medium comprising a first substrate and a second substrate having a holographic recording layer between the first substrate and the second substrate, the holographic recording layer containing:

(A) a binder compound having a reactive group;
(B) a polymerizable compound having an ethylenic double bond;
(C) a photoinitiator; and
(D) a cross-linking agent which reacts with the reactive group in the binder compound,

wherein the photoinitiator contains a compound represented by Formula (1):

Formula (1)

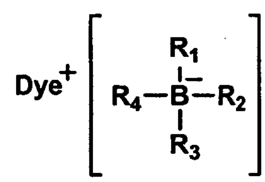

wherein Dye⁺ is a cationic dye, each $R^1$ to $R^4$ is independently a substituted or unsubstituted alkyl, aryl, aralkyl, alkenyl, alkynyl, heterocylic group, or a cyano group, provided that two or more of $R^1$ to $R^4$ can form a ring.
2. The holographic recording medium of Item 1, wherein at least one of $R^1$ to $R^4$in Formula (1) is a substituted or unsubstituted alkyl, aralkyl, alkenyl or alkynyl group; and at least one of $R^1$ to $R^4$ is a substituted or unsubstituted aryl or heterocyclic group.
3. The holographic recording medium of Item 1, wherein $Dye^+$ in Formula (1) is a dye selected from the group consisting of methine dyes, polymethine dyes, triarylmethane dyes, indoline dyes, azine dyes, thiazine dyes, xanthene dyes, oxazine dyes, acridine dyes, cyanine dyes, carbocyanine dyes, hemicyanine dyes, rhodacyanine dyes, azomethine dyes, styryl dyes, pyrylium dyes, thiopyrylium dyes and metal complex compounds represented by Formula (2):

Formula (2) $M^{n+}$ (L) x

wherein M is a metal atom, n is an integer of 1 to 4, L is a ligand and x is an integer of 1 to 6.
4. The holographic recording medium of Item 3, wherein L in Formula (2) is a dye capable of coordinating with M, provided that a coordination number of L with M is 2 or more.
5. The holographic recording medium of Item 1, wherein the cross-linking agent contains a siloxane bond or a fluorine-carbon bond in the molecule.
6. The holographic recording medium of Item 1, wherein the reactive group in the binder compound is selected from the group consisting of a hydroxy, mercapto, carboxyl, amino, epoxy, oxetane, isocyanate, carbodiimide, oxadiazine, and metal alkoxide group.
7. The holographic recording medium of Items 5 or 6,
wherein the binder compound is a liquid at 20 °C or has a melting point of not more than 50 °C.

8. The holographic recording medium of Item 1, wherein the polymerizable compound contains an acryloyl or methacryloyl group in the molecule.
9. The holographic recording medium of Item 1, wherein the polymerizable compound has a refractive index of not less than 1.55.
10. The holographic recording medium of Item 1, wherein a thickness of the first substrate (d1), a thickness of the second substrate (d2) and a thickness of the holographic recording layer (Dh) satisfy the following formula:

$$0.15 \leq Dh/(d1 + d2) \leq 2.0$$

11. The holographic recording medium of Item 10, wherein the thickness of the holographic recording layer (Dh) is 200 μm to 2.0 mm.
12. The holographic recording medium of Item 10, wherein the thickness of the first substrate (d1) and the thickness of the second substrate (d2) satisfy the following formula:

$$d1 \leq d2$$

13. The holographic recording medium of Item 1, wherein the first substrate is transparent and has an antireflective outer surface and an inner surface, the antireflective outer surface being opposite to the inner surface and the inner surface facing the holographic recording layer.
14. The holographic recording medium of Item 1, wherein the first substrate is a glass plate.
15. The holographic recording medium of Item 1, wherein an inner surface or an outer surface of the second substrate is coated with a reflective layer having a reflective index of not less than 70%, the inner surface being a surface which has the holographic recording layer thereon.
16. The holographic recording medium of Item m 1, wherein a shape of the holographic recording medium is a disc form.
17. The holographic recording medium of Item m 1, wherein a shape of the holographic recording medium is a card form.
18. A method of forming a holographic image using a holographic recording medium comprising a first substrate and a second substrate having a holographic recording layer between the two substrate, the holographic recording layer containing:

(A) a binder compound having a reactive group;
(B) a polymerizable compound having an ethylenic double bond;
(C) a photoinitiator;
(D) a cross-linking agent which reacts with the reactive group in the binder compound,

wherein the photoinitiator contains a compound represented by Formula (1),
the method comprising the steps of:

(i) irradiating the holographic recording medium with a first light so as to cross-link the binder compound and the cross-linking agent, provided that the first light has not a property of activating the photoinitiator;
(ii) irradiating the holographic recording medium with a second light based on information to be recorded so as to activate the photoinitiator;
(iii) polymerizing the activated photoinitiator with the polymerizable compound(B) to form the holographic image.

19. The holographic image forming method of Item 18, comprising further the step of:

(iv) irradiating the holographic recording medium with a light or subjecting the holographic recording medium so as to stabilize the holographic image after completion of the step (iii).

20. A method of forming a holographic image using a holographic recording medium comprising a first substrate and a second substrate having a holographic recording layer between the two substrate, the holographic recording layer containing:

(A) a binder compound having a reactive group;

(B) a polymerizable compound having an ethylenic double bond;
(C) a photoinitiator;
(D) a cross-linking agent which reacts with the reactive group in the binder compound,

wherein the photoinitiator contains a compound represented by Formula (1),
the method comprising the steps of:

(i) irradiating the holographic recording medium with a light based on information to be recorded so as to activate the photoinitiator;
(ii) polymerizing the activated photoinitiator with the polymerizable compound to form the holographic image; and
(iii) irradiating the holographic recording medium with a light or subjecting the holographic recording medium so as to stabilize the holographic image after completion of the step (ii).

## PREFERRED EMBODIMENTS TO ACHIEVE THE INVENTION

In the following, a holographic recording medium of the present invention will be detailed.
The holographic recording composition employed in a recording layer of a holographic recording medium of this invention is characterized by containing a binder compound

(A) provided with a reactive group, a polymerizing compound
(B) provided with an ethylenic double bond, a photo-polymerization initiator(C), and a cross-linking agent (D) provided with a functional group which can react with the reactive group of the aforesaid binder compound (A) provided with a reactive group, as well as at least a compound represented by the aforesaid Formula (1) as said photo-polymerization initiator (C).

Since in a complex of a cationic dye and a boric anion which is contained at least as a photo-polymerizing initiator (C), that is an indispensable component of the aforesaid holographic recording composition, the boric anion portion of which generates a radical, is located in the neighborhood of the cationic dye as a sensitizing dye, it can generate radials efficiently as well as be easily fit to the wavelength of the light source for holographic exposure by varying the structure of the cationic dye, compared to a initiator system comprising a combination of a conventional photo-radical initiator and a sensitizing dye which spectrally sensitizes said initiator against the exposing wavelength of the light source for holographic exposure.
Further, boric anions in the compounds represented by Formula (1) include the anions listed below.

B-1
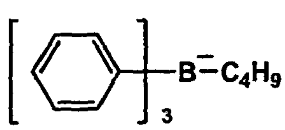
B-2
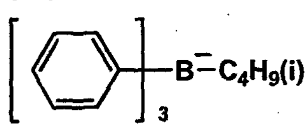
B-3
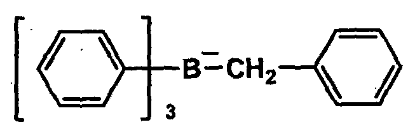

B-4
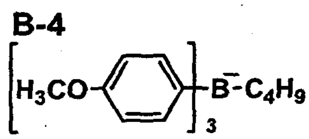
B-5
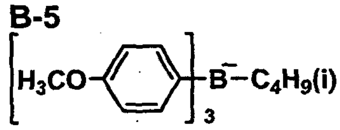
B-6
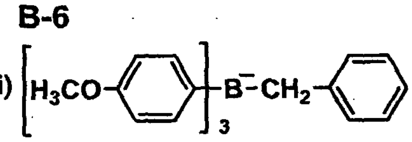

B-7
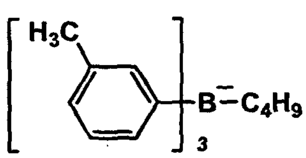
B-8
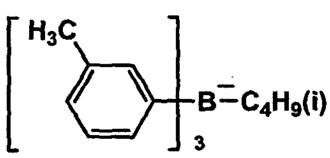
B-9
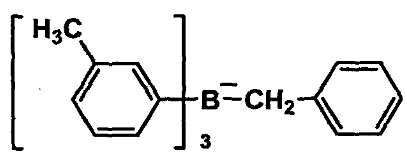

B-10

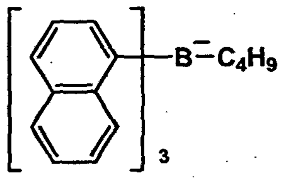

B-11

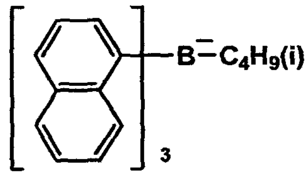

B-12

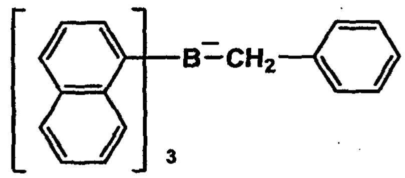

B-13

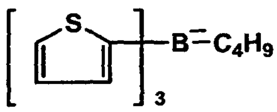

B-14

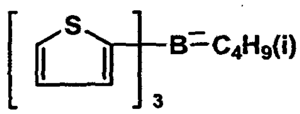

B-15

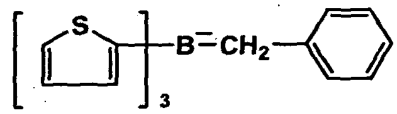

B-16

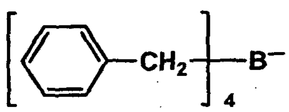

B-17

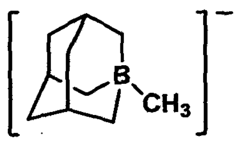

B-18

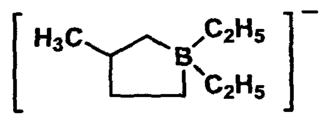

B-19

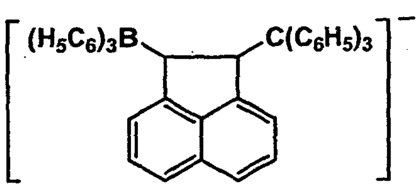

B-20

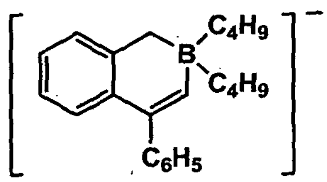

B-21

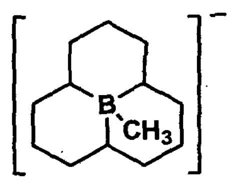

B-22

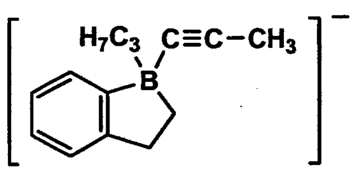

B-23

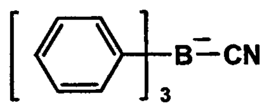

B-24

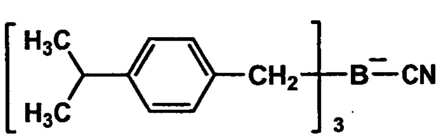

B-25

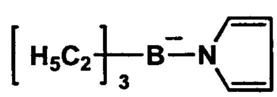

B-26

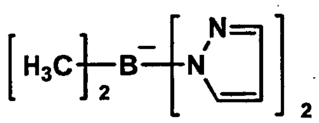

B-27

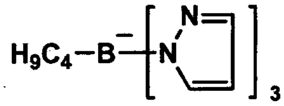

Herein, to generate radicals efficiently among the aforesaid boric anions, at least one of the substituents represented by $R_1$ - $R_4$ of the boric anion portion is preferably a substituted or non-substituted alkyl group, alalkyl group, alkenyl group or alkynyl group, and the others are any of substituted or non-substituted aryl groups and heterocyclic groups; such alkyl groups include a straight-chain alkyl and a chain alkyl, and listed are such as a methyl group, an ethyl group, a butyl group, an isobutyl group, a hexyl group, an octyl group and a stearyl group. Alkenyl groups and alkynyl groups are preferably those having a carbon number of 2 - 20. Cycloalkyl groups are preferably those having a 5 - 7 membered ring. An aralkyl group is preferably a benzyl group. A heterocyclic group preferably has an aromatic property, and includes, for example, a thiophene group. An aryl group is preferably a phenyl group or a naphthyl group. These groups may be further substituted, and listed as substituents are a halogen atom, a cyano group, a nitro group, an alkyl group, an aryl group, a hydroxy group, an amino group (including an alkyl substituted amino group), an alkoxy group, a carbamoyl group, -COOR and - OCOR (R is an organic group such as an alkyl group and an aryl group).

Further, as the cationic dyes represented by $Dye^+$ in the compounds represented by Formula (1), can be utilized are cationic dyes conventionally utilized in various applications by suitable selection, and preferable among them are methine dyes, polymethine dyes, triarylmethane dyes, indoline dyes, azine dyes, thiazine dyes, xanthene dyes, oxazine dyes, acridine dyes, cyanine dyes, carbocyanine dyes, hemicyanine dyes, rhodacyanine dyes, azamethine dyes, styryl dyes, pyrylium dyes, thiopyrylium dyes and coordination metal complexes represented by following Formula (2).

Formula (2) $M^{n+}(L)_x$

(wherein M represents a metal atom, n represents an integer of 1 - 4, L represents a ligand and x represents an integer of 1 - 6)

Further, a ligand represented by L in Formula (2) is preferably a dye capable of chelating having at least 2 coordination number against a metal ion with respect to stability of the coordination metal complex, as well as to easy adjustment of maximum spectral wavelength in the case of the wavelength of the light source for holographic exposure being 500 nm or longer.

Such dyes capable of chelating with a coordination 2 or more include the following dyes.

L-1

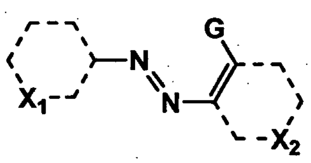

L-2

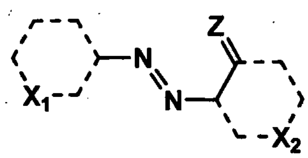

L-3

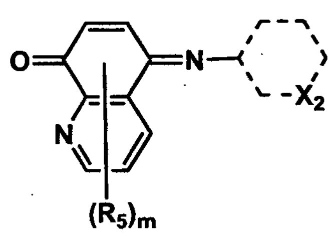

L-4

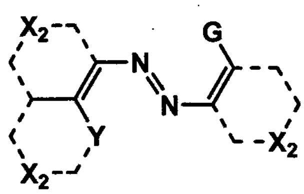

L-5

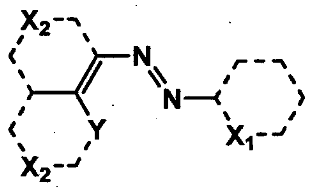

L-6

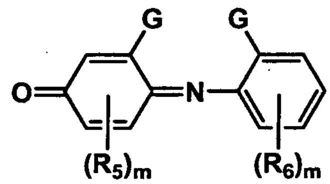

L-7

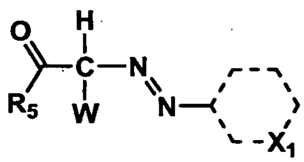

L-8

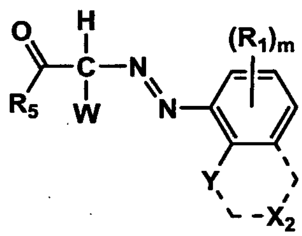

L-9

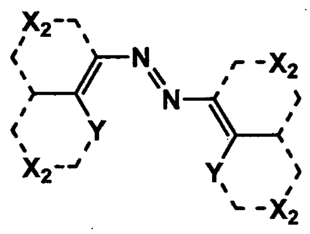

wherein, $X_1$ represents an atomic group necessary to complete an aromatic carbon ring or a heterocyclic ring in which at least one of the adjacent positions to the carbon bonding to an azo bond is substituted by a nitrogen, oxygen, sulfur, selenium or tellurium atom and at least one ring is comprised of 5 - 7 atoms, and $X_2$ represents an atomic group necessary to complete a carbon ring or a heterocyclic ring,
wherein each of a carbon ring and a heterocyclic ring may be substituted. G represents a chelating group, W represents - $COR_7$ or $-CSR_7$, Y represents -O-, -S-, -N=, -NH- or $-NR_8-$, Z represents O or S, and m and n represent integers of 1 - 5. $R_1$ and $R_2$ represent a hydrogen atom, a halogen atom, a cyano group, an alkyl group, an alkenyl group, an alkoxy group, an alkylsulfonamide group, an arylsulfonamide group, an anilino group, an acylamino group, an alkylureido group, an arylureido group, an alkoxycarbonyl group, an alkoxycarbonyl amino group, a carbamoyl group, a sulfamoyl group, a sulfo group, a carboxy group, an aryl group or a heterocyclic group. $R_7$ represents a hydrogen atom, an alkyl group, an alkenyl group, an alkoxy group, an alkylsulfonamide group, an arylsulfonamide group, an anilino group, an acylamino group, an alkylureido group, an arylureido group, a carbamoyl group, a sulfamoyl group, a sulfo group, an aryl group or a heterocyclic group; and $R_8$ represents an alkyl group, an alkenyl group, an aryl group or a heterocyclic group.)

Further, metal ions represented by $M^{n+}$ in aforesaid Formula (2) include such as silver (I), aluminum (III), gold (III), cerium (III, IV), cobalt (II, III), chromium (III), copper (I, II), europium (III), iron (II, III), gallium (III), germanium (IV), indium (III), lanthanum (III), manganese (II), nickel (II), palladium (II), platinum (II, IV), rhodium (II, III), ruthenium (II, III, IV), scandium (III), silica (IV), samarium (III), titanium (IV), uranium (IV), zinc (II) and zirconium (IV); preferable among them are tetra- or hexa-dentately coordinating metal ions in case of bidentate coordinating dyes, and preferable are hexa-dentately coordinating metal ions in case of tridentate coordinating dyes. Specifically preferable metal ions can include zinc (II), nickel (II), cobalt (II, III), copper (II), rhodium (II, III), ruthenium (II, III), palladium (II) and platinum (II, IV).

Each "bidentate", "tridentate" and "tetradentate" and "hexa-dentate" means a coordination number 2, 3, 4 and 6 respectively.

Herein, the aforesaid complexes of a cationic dye and a boric anion may be utilized alone or in combination of two or more types. Further, in addition to the photo-polymerization initiator (C) which is indispensable in this invention and detailed above, appropriately incorporated are photo-polymerization initiator systems combining a photo-polymerization initiator which is selected from commonly known carbonyl compounds such as benzoin and derivatives thereof and benzophenone, azo compounds such as azobisisobutylonitrile, sulfur compounds such as dibenzothiazolylsulfide,

peroxide compounds such as benzoyl peroxide, halogen compounds such as 2-tribromomethanesulfonyl pyridine, onium compounds such as an iodonium salt and a sulfonium salt, metal $\pi$ complexes such as an iron allen complex and a titanocene complex, together with a sensitizing dye to spectrally sensitize said photo-polymerization initiators against wavelength of the light source for holographic exposure.

These photo-polymerization initiators are generally utilized in a range of from 0.01 weight part to 25 weight parts against the photo-polymerizing compound (B) provided with an ethylenic double bond, although it cannot be determined indiscriminately depending on the molecular weight of a photo-polymerization initiator (C) and the content ratio of the ethylenic double bond in the photo-polymerizing compound (B) provided with an ethylenic double bond.

Next, a binder compound (A) provided with reactive groups, which is indispensable as a component of a holographic recording composition, will be explained.

The aforesaid binder compounds are preferably liquid at ordinary temperature or have a melting point of 100 °C or lower and are furthermore preferably liquid at ordinary temperature or have a melting point of 50 °C or lower to prevent the deterioration of a photo-polymerization initiator (C) due to heat, because the recording composition of a liquid state at ordinary temperature or of a liquid state at a temperatures of 100 °C or lower is sandwiched between two sheets of substrates at a predetermined thickness to prepare a holographic recording medium of this invention, which will be detailed below.

Further, it is preferable to partly fix the recording composition in a medium after formation of the medium or to fix the recorded information after holographic recording, and as the means for such fixation, the objective can be achieved by causing a cross-linking reaction between a binder compound (A) provided with reactive groups and a cross-linking agent (D) provided with a functional group capable of reacting with the reactive group of said binder compound (A). Wherein, the reactive group of the binder compound (A) provided with reactive groups are not specifically limited provided being capable of reacting with said cross-linking agent (D), and preferable among them are those provided with at least one type of reactive group selected from a hydroxyl group, a mercapto group, a carboxyl group, an amino group, an epoxy group, an oxetane group, an isocyanate group, a carbodiimide group, an oxazine group and metal alkoxides.

Further, since holographic recording provides a refractive index difference between the holographic exposed portion and the non-exposed portion by diffusion polymerization of a monomer, it is preferable to provide a refractive index difference between the binder matrix, formed by the binder compound (A) provided with reactive groups and the cross-linking agent (D) provided with a functional group capable of reacting with said binder compound (A) provided with reactive groups, and polymerizing compound (B) provided with an ethylenic double bond in the molecule which will be described below. Therefore, the cross-linking agent (D) provided with a functional group capable of reacting with the binder compound (A) or the reactive group of said binder compound (A) provided with reactive groups is preferably a compound having a siloxane bond or a carbon-fluorine bond to form a binder matrix having a lower refractive index in the case of employing a compound having a refractive index of around 1.50 as the polymerizing compound (B) provided with an ethylenic double bond.

Herein, such binder compounds may be utilized alone or in combination of two or more types; they are generally contained at 10 - 95 weight% and preferably at 20 - 80 weight%, in the holographic recording composition.

Further, a cross-linking agent (D) provided with a functional group capable of reacting with the reactive group of the binder compound (A) provided with reactive groups, which is indispensable component of the holographic recording composition, is not specifically limited provided being capable of reacting with the reactive group of the binder compound (A), and, for example, utilized can be a cross-linking agent having such as an isocyanate group, a carbodiimide group or a metal alkoxide when the binder compound is provided with a hydroxyl group; a cross-linking agent having such as an isocyanate group, a carbodiimide group or an epoxy group when it is provided with a mercapto group; a cross-linking agent having such as an oxetane group, a carbodiimide group, an oxazine group or a metal alkoxide when it is provided with a carboxyl group; a cross-linking agent having such as an isocyanate group, an epoxy group, or an acid anhydride when it is provided with an amino group; a cross-linking agent having such as a mercapto group, an amino group, a carboxyl group or a sulfonic acid group when it is provided with an epoxy group; a cross-linking agent having such as a carboxyl group or a sulfonic acid group when it is provided with an oxetane group; a cross-linking agent having such as a hydroxyl group, a mercapto group or an amino group when it is provided with an isocyanate group; a cross-linking agent having such as a hydroxyl group, a mercapto group, a carboxyl group or an sulfonic acid group when it is provided with a carbodiimide group; a cross-linking agent having such as carboxyl group or a sulfonic group when it is provided with an oxazine group. Herein, a cross-linking agent may be either one originally provided with a functional group capable of reacting with a binder resin having reactive groups or one like a precursor which can generate a functional group by applying other energy such as heat or light.

Herein, these may be utilized alone or in combination of two or more types and are generally contained at 0.1 - 70 weight% and preferably at 0.5 - 50 weight%, in the holographic recording composition.

Next, explained will be the polymerizing compound (B) provided with an ethylenic double bond in the molecule which is indispensable as a component of a holographic recording composition.

The polymerizing compound (B) provided with an ethylenic double bond in the molecule employed in this invention is not specifically limited provided having an ethylenic double bond in the molecule, and is preferably provided with an acyloxy group or an acylamide group in the molecule in view of such as adhesion with the substrate and compatibility with a binder compound (A) at the time of being formed into a recording medium, and is more preferably a compound provided with a (meth)acryloyl group further with respect to steric hindrance at the time of performing radical polymerization. Herein, a meth(acryloyl) group referred in this invention represents an acryloyl group or a methacryloyl group.

Such compounds provided with a (meth)acryloyl group include, for example, phenol, nonylphenol, and (meth) acrylate or (meth)acrylamide of 2-ethylhexanol, in addition to (meth)acrylate or (meth)acrylamide of the alkyleneoxide adducts of these alcohols, as compounds having one (metha)acryloyl group. Listed are bisphenol A, isocyanulic acid and di(meth)acrylate or di(meth)acrylamide of fluorene, in addition to di(meth)acrylate or di(meth)acrylamide of the alkyleneoxide adducts of these alcohols, and di(meth)acrylate or di(meth)acrylamide of polyalkyleneglycols such as ethyleneglycol and propyleneglycol, as compounds having two (metha)acryloyl groups. Listed are pentaerythritol, trimethylolpropane and tri(meth)acrylate or tri(meth)acrylamide of isocyanuric acid, in addition to tri(meth)acrylate or tri (meth)acrylamide of the alkyleneoxide adducts of these alcohols, as compounds having three (metha)acryloyl groups; and poly(meth)acrylate or poly(meth)acrylamide of pentaerythritol and dipentaerythritol as compounds having four or more (metha)acryloyl groups. Further, acryl- or acrylamide-type monomer and/or oligomer conventionally known such as urethane acrylate having a urethane bond as the main chain, polyester acrylate having an ester bond as the main chain, and epoxy(meth)acrylate in which an acrylic acid is added to an epoxy compound are also appropriately selected to be utilized in this invention.

Herein, the compounds having plural (meth)acryloyl groups may be provided with (meth)acrylate alone or (meth)acrylamide alone, or may be provided with (meth)acrylate and (meth)acrylamide.

To provide the polymer obtained by diffusion polymerization of polymerizing compound (B) provided with an ethylenic double bond a significant refractive index difference against the binder matrix formed from the cross-linking agent (D) provided with a functional group capable of reacting with said reactive group of the aforesaid binder compound (A) provided with reactive groups, it is preferable to employ said polymerizing compound having a higher refractive index or a lower refractive index compared to those of the binder compound (A) and/or the cross-linking agent (D). Specifically, it is preferable to employ the binder compound (A) and/or the cross-linking agent (D) having a refractive index of at least 1.55 in the case of employing a compound having a refractive index of around 1.50 as the binder compound (A) and/or the cross-linking agent (D), with respect to obtaining a polymer of a polymerizing compound (B) having a high refractive index.

Herein, these polymerizing compounds (B) having an ethylenic double bond in the molecule may be utilized alone or in combination of two or more types, and they are generally contained at 2 - 80 weight% and preferably at 5 - 70 weight% in the holographic recording composition.

Further, in this invention, as other than the aforesaid indispensable components, utilized by appropriate selection may be such as reaction accelerators for the purpose of accelerating the reaction of a binder compound (A) provided with reactive groups and a cross-linking agent (D) having a functional group capable of reacting with the reactive group of a binder compound (A), thermal expanding agents for the purpose of preventing thermal shrinkage after recording, thermal polymerization inhibitors to prevent thermal polymerization at the time of preparation of the recording composition, and plasticizers or thermally-fusing compounds to control the liquid viscosity at the time of preparation of the recording composition.

Next, a holographic recording medium of this invention will be detailed.

A holographic recording medium of this invention is characterized in that a holographic recording layer is sandwiched between the first and second substrates and said holographic recording layer contains a binder compound (A) provided with reactive groups, a polymerizing compound (B) provided with an ethylenic double bond in the molecule, a photo-polymerization initiator (C) and a cross-linking agent (D) provided with a functional group capable of reacting with the reactive group of the aforesaid binder compound (A) provided with reactive groups, as well as at least a compound represented by aforesaid Formula (1) as said photo-polymerization initiator (C).

Herein, a binder compound (A) provided with reactive groups, a polymerizing compound (B) provided with an ethylenic double bond in the molecule, a photo-polymerization initiator (C), a cross-linking agent (D) provided with a functional group capable of reacting with the reactive group of said binder compound (A) provided with reactive groups, and a compound presented by Formula (1) which is at least contained in a recording layer as said photo-polymerizing initiator (C) have the same definitions as detailed in the aforesaid holographic recording composition.

Next the first and second substrates constituting a recording medium will be explained. Herein, the first substrate is a substrate on the incident side of information light and reference light at the time of holographic exposure for information recording or a substrate on the irradiation side of reproduction light for reproduction, and the second substrate is a substrate on the opposite to said first substrate sandwiching a holographic recording layer.

As the first and second substrates employed in a recording medium of this invention, utilized without specific

restriction can be those being transparent and causing no shrinkage nor bending under using ambient temperatures, as well as inactive against the aforesaid recording composition, and listed as such substrates are glasses such as quartz glass, soda glass, potash glass, lead crystal glass, boric silicate glass, aluminum silicate glass, titanium crystal glass and crystallized glass, and various types of resins such as polycarbonate, polyacetal, polyallylate, polyetheretherketone, polysulfon, polyethersulfon, polyimides such as polyimidoamide and polyetherimide, polyamide and polyolefins such as cyclic olefin-type open chain polymerization products.

Among the aforesaid substrates, glass is preferred as the first substrate which is at the incident side of information light and reference light, in view of thickness variation due to ambient temperature and humidity or gas permeability at the time of holographic exposure as well as transmittance of light at the wavelength of the light source employed for holographic exposure. Further, glass is preferred as the second substrate similarly to the first substrate, however, substrates comprising resin may be utilized instead of glass, in which shrinkage rate or thickness variation is restrained, when a device equipped with a focus compensation mechanism at the time of reading out the holographic recorded information by use of CCD.

Further, the light transmittance of incident light over the first substrate which is on the incident side of information light and reference light is at least 70% and more preferably at least 80%, with respect to minimizing the loss of light reaching to a holographic recording layer. To increase the transmittance as much as possible, the substrate plane opposite to the surface, on which a holographic recording layer is accumulated, is preferably subjected to an anti-reflection treatment; as such an anti-reflection treatment there is no specific restriction as far as the refractive index is lower than that of the first substrate, and preferable are, for example, inorganic metallic fluorides such as $ALF_3$, $MgF_2$, $ALF_3 \cdot MgF_2$ and $CaF_2$; homopolymers, copolymers, graft polymers and block polymers containing a fluorine atom such as vinylidenefluoride and teflon(R); and organic fluorides such as modified polymers modified by a functional group containing a fluorine atom; with respect to achieving a lower refractive index of a substrate than those detailed above.

Further, methods to provide a layer comprising a compound of a fluoride type on the substrate, are not indiscriminately determined depending on the types of the support and the fluoride type compound, however, employed can be commonly known methods such as a sol-gel method, a vacuum evaporation method, a sputtering method, a CVD method and a coating method, or methods described in such as JP-A Nos. 7-27902, 2001-123264 and 2001-264509, by appropriate selection.

Such an anti-reflection layer cannot be indiscriminately defined depending on surface treatments and materials, and is generally in a range of 0.001 - 20 μm thick and preferably in a range of 0.005 - 10 μm thick.

Further, a reflecting layer is preferably provided on the surface of the second substrate on which a holographic recording layer is accumulated or on the opposite surface of a recording medium employed in a holographic recording and/or reproducing device of such as JP-A No. 2002-123949 and World Patent No. 99/57719, and preferable is the reflectance of at least 70% and more preferably at least 80% against the wavelength of the reflecting light when a reflecting layer is provided.

Such a reflective layer is not specifically restricted as for the materials provided that a desired reflectance is obtained, and can be accumulated by providing a thin layer of such as a metal on the substrate surface. For example, to form such a reflective layer, a metallic thin layer is provided as a single crystal or multi-crystal by means of commonly known methods such as a vacuum evaporation method, an ion plating method and a sputtering method; and employed can be metals alone or in combination of two or more kinds selecting from such as aluminum, zinc, antimony, indium, selenium, tin, tantalum, chromium, lead, gold, silver, platinum, nickel, niobium, germanium, silica, molybdenum, manganese, tungsten and palladium. The thickness of the metallic thin layer is not specifically limited depending on the substrate surface property or the materials and is generally in a range of 1 - 3000 nm and preferably in a range of 5 - 2000 nm.

On the other hand, in a holographic recording medium, prepared can be a recording medium having a large memory capacity by making a holographic recording layer thick as much as possible, however, in this invention, it is preferable to satisfy the relationship of $0.15 \leq Dh/(d1 + d2) \leq 2.0$ when the thickness of the first substrate is d1, that of the second substrate is d2 and that of a holographic recording layer is Dh, with respect to the utilizing environment of said recording medium or errors at reading recorded information.

Herein, the thickness of a holographic recording layer cannot be made thick when $0.15 > Dh/(d1 + d2)$, or the thickness of the substrate becomes thick resulting in making the total thickness of a recording medium thick even when the thickness of the recording layer is made thick. In this case, it is not preferable that the weight of a recording medium itself becomes heavy which may result in causing a burden onto the driving system of the apparatus. While, when $Dh/(d1 + d2) > 2.0$, it is possible to make the thickness of a recording medium thinner keeping the thickness of the recording layer, however, it is not preferable that the thickness of the recording layer becomes thicker compared to that of the substrate which may result in poor plane precision of the recording medium and uneven thickness of the recording layer under using ambient temperature, in addition to thickness variation of the recording layer and slippage between the first and second substrates in case of receiving unexpected stress.

Further, the relationship between the thickness of the first substrate d1 and the thickness of the second substrate d2 preferably satisfies $d1 \leq d2$ with respect to energy loss at the time of holographic exposure, and the thickness ratio of d1 and d2 is more preferably in a range of $0.20 \leq d1/d2 \leq 1.00$ to maintain the flatness of the recording medium.

Further, the thickness of a holographic recording layer Dh cannot be indiscriminately determined depending on such as a diffraction efficiency, a dynamic range and a spatial resolution, however, is preferably at least 200 μm and at most 2.0 mm; it is not preferred that a recording medium having a high memory capacity is hardly obtained when it is less than 200 μm and poor plane precision of the recording medium and uneven thickness of the recording layer under using ambient temperature may result when it is more than 2.0 mm.

The shape of a recording medium is not specifically limited provided being suitable for holographic recording and/or reproducing devices, however, for example, a disc shape is preferred in the case that the devices described in such as USP No. 5,719,691 and JP-A No. 2002-123949 are employed and a card shape is preferred in the case that the devices described in such as World Patent No. 99/57719 are employed.

As a method to prepare the recording media detailed above, a holographic recording layer forming composition is prepared by mixing the holographic recording composition under safelight at ordinary temperature or appropriately being heated; the holographic recording composition kept at ordinary temperature or appropriately being heated is applied on the first substrate after being degassed to depress polymerization inhibition at the time of holographic exposure; successively after laminating the second substrate without introducing any foams so as to make the predetermined thickness; the resulting system is finally sealed at the edges to produce a recording medium. Further, a recording medium can be produced by fixing the first and second substrate in a form to keep a predetermined interval under safe light, followed by injection molding a holographic recording composition at ordinary temperature or appropriately being heated without introducing any foams, or filling the composition between the first and second substrates by means of suction with reduced pressure not as to introduce any foams, and finally sealing the edges. Herein, "under safe light" indicates operation under the state where the wavelengths of the light to activate photo-polymerization initiator and those to be employed in the case of utilizing light to form the binder matrix are cut.

Further, in the case of preparing a recording medium by means of lamination, a holographic recording layer forming composition may be applied also on the second substrate instead of on the first substrate as described above, or on the both of the first and second substrates. In addition to this, to seal the edges of the first substrate, a holographic recording layer and the second substrate, sealing may be performed by cross-linking a sealing material of a liquid state capable of sealing or by employing a sealing material of a ring-shape to make the predetermined thickness.

Next, a method to record information on a holographic recording medium will be detailed.

The first embodiment according to holographic recording methods of this invention is characterized in that a holographic recording layer is sandwiched between the first and second substrates, said holographic recording layer including a binder compound (A) provided with reactive groups, a polymerizing compound (B) provided with an ethylenic double bond in the molecule, a photo-polymerization initiator (C) and a cross-linking agent (D) provided with a functional group reactive with the reactive group of the binder compound (A) provided with reactive groups as well as at least a compound represented by Formula (1) and holographic recording on the holographic recording medium being performed, wherein information is recorded on the holographic recording medium by cross-linking a binder compound (A) provided with reactive groups and a cross-linking agent (D) provided with a functional group with heat or light irradiation which cannot activate a photo-polymerization initiator (C), before holographic exposure, followed by activating the photo-polymerization initiator (C) with a holographic exposure based on the information to be recorded, and diffusion polymerizing a polymerizing compound (B) provided with an ethylenic double bond in the molecule.

In the case of a heavy thickness layer is applied, since the recording layer forming composition is prepared generally without a solvent for dilution, it becomes difficult with a solid or highly viscous composition to obtain a uniform layer thickness or to eliminate foams involved at the time of preparing the composition. Therefore, the recording layer forming composition is necessary to have a fluid property in a state at ordinary temperature or being heated when it has been prepared. Specifically, in the case that the recording layer forming composition is liquid and has a low viscosity at ordinary temperature, it is not preferable that the flatness as a recording medium may be hardly retained, or the polymers formed by diffusion polymerization of a polymerizing compound (B) may possibly be dislocated in a recording layer after information having been recorded by holographic exposure.

Therefore, in the holographic recording medium containing the aforesaid indispensable components, it is possible to insure the flatness and prevent migration of the polymer formed by diffusion polymerization of a polymerizing compound (B) in the recording layer by cross-linking a binder compound (A) provided with reactive groups and a cross-linking agent (D) provided with a functional group with heat or light irradiation which cannot activate the photo-polymerizing initiator (C) before holographic exposure to form a binder matrix.

In this way, it is possible to record information on a holographic recording medium by performing holographic exposure based on information to be recorded after a binder matrix having been formed, and activating a photo-polymerization initiator (C) to perform diffusion polymerization of a polymerizing compound (B) provided with an ethylenic double bond in the molecule by this active species.

Herein, in a cross-linking reaction to form a binder matrix of this recording method, reacted may be all of the binder compound (A) provided with reactive groups and cross-linking agent (D) provided with a functional group or only a part of them within a range of not causing practical troubles. Further, to fix holographic information recorded after finishing information recording on a holographic recording medium, it is preferable to complete polymerization, with light and heat appropriately applied, of the residual binder compound (A) provided with reactive groups and cross-linking agent (D) provided with a functional group in addition to polymerizing compound (B) provided with an ethylenic double bond in the molecule. In this case, light employed for the exposure is preferably exposed at once over the whole recording medium.

The second embodiment according to holographic recording methods of this invention is characterized in that a holographic recording layer is sandwiched between the first and second substrates, said holographic recording layer containing a binder compound (A) provided with reactive groups, a polymerizing compound (B) provided with an ethylenic double bond in the molecule, a photo-polymerization initiator (C) and a cross-linking agent (D) provided with a functional group reactive with the reactive group of the binder compound (A) provided with reactive groups as well as at least a compound represented by Formula (1), and holographic recording being performed on the holographic recording medium, wherein after performing holographic exposure based on information to be recorded to activate a photo-polymerization initiator (C), information is recorded on the holographic recording medium by diffusion polymerization of a polymerizing compound (B) provided with an ethylenic double bond in the molecule with this active species, and further heat or light is irradiated all over the holographic recording medium after finishing information recording on the holographic recording medium to stabilize the recorded information.

This embodiment, different from the aforesaid first embodiment, is a recording method effective for holographic recording media the recording layer of which is comprised of a recording layer forming composition which flows in a state of being heated while does not flow at ordinary temperature, or a recording layer forming composition which is gelled at ordinary temperature as far as shearing stress is not applied and having a thixotropic property, when the recording layer forming composition has been prepared.

In such recording media, it is possible to achieve the level causing no problem in practical application with respect to insuring the flatness of said recording media and preventing migration of the polymer formed by diffusion polymerization of a polymerizing compound (B), however it is preferable to complete polymerization, with light and heat appropriately applied, of the residual binder compound (A) provided with reactive groups, cross-linking agent (D) provided with a functional group and polymerizing compound (B) provided with an ethylenic double bond in the molecule after information has been recorded on the holographic recording media for the purpose of fixing the recorded holographic information, wherein, light employed for the exposure is preferably exposed at once over the whole recording medium.

Further, as methods and apparatuses for recording and/or reproducing of a holographic recording media according to this invention, employed can be any of those proposed provided that being capable of recording and/or reproducing with the recording media of this invention; listed as such methods and apparatuses for recording and/or reproducing are those described in, for example, in USP Nos. 5,719,691, 5,838,467, 6,163,391, 6,414,296, US Patent Publication Open to Public Inspection No. 2002-136143, JP-A Nos. 9-305978, 10-124872, 11-219540, 2000-98862, 2000-298837, 2001-23169, 2002-83431, 2002-123949, 2002-123948, 2003-43904, World Patent Nos. 99/57719, 02/05270 and 02/75727. Laser light sources employed in the aforesaid methods and apparatuses for recording and/or reproducing are not specifically limited, provided that they can record holographic record information by activating a photo-polymerization activator in the recording medium and to read out the recorded hologram, and include such as a semiconductor laser of a blue light region, an argon laser, a He-Cd laser, a YAG laser of a double frequency, a He-Ne laser, a Kr laser and a semiconductor laser of a near infrared region.

## EXAMPLES

This invention will be specifically explained in reference to examples in the following, however, embodiments of this invention are not limited thereto.

<Preparation of Holographic Recording Layer Forming Composition>

(Holographic Recording Layer Forming Composition 1)

Solution 1 containing 98.86 weight% of 4-chlorophenyl acrylate (a refractive index of 1.536) and 1.14 weight% of dibutyltin dilaurylate was prepared. Next, under safelight, 1.70 g of solution 1, 25.19 g of diisocyanate-end polypropyleneglycol (a molecular weight of 2471) and 4.70 g of $\alpha,\omega$-dihydroxy polypropyleneglycol (a molecular weight of 425) were mixed, and initiator solution 1, separately prepared, containing 5.10 g of 4-chlorophenyl acrylate (above-described), 0.063 g of a photo-polymerization initiator (Irgacure 784, manufactured by Ciba Special Chemicals Co., Ltd.)

and 0.0063 g of a sensitizing dye (Dye-1) was added to aforesaid solution. Finally, the prepared composition was degassed with nitrogen, and the gas components occluded were eliminated by use of a ultrasonic washer resulting in preparation of holographic recording layer forming composition 1 as a comparative sample.

Dye-1

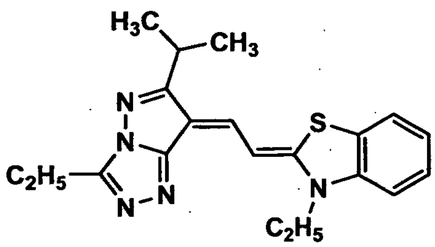

(Holographic Recording Layer Forming Composition 2)

Solution 2 was prepared by mixing 9.697 g of propyleneglycol diglycidylether (Epolight 200P, manufactured by Kyoeisha Chemicals Co., Ltd.), 6.042 g of pentaerythritol (tetrakismercapto propionate) and 0.840 g of 2,4,6-tris (dimethylaminomethyl)phenol. Initiator solution 2, separately prepared, containing 2.194 g of 4-bromostyrene (a refractive index of 1.594), 0.126 g of a photo-polymerization initiator (Irgacure 784, manufactured by Ciba Special Chemicals Co., Ltd.) and 0.0126 g of a sensitizing dye (Dye-1) was added to aforesaid solution 2. Finally, the prepared composition was degassed with nitrogen, and the gas components occluded were eliminated by use of a ultrasonic washer resulting in preparation of holographic recording layer forming composition 2 as a comparative sample.

(Holographic Recording Layer Forming Composition 3)

Solution 2 was prepared by mixing 9.697 g of propyleneglycol diglycidylether (Epolight 200P, manufactured by Kyoeisha Chemicals Co., Ltd.), 6.042 g of pentaerythritol (tetrakismercapto propionate) and 0.840 g of 2,4,6-tris (dimethylaminomethyl) phenol. Initiator solution 3, separately prepared, containing 2.189 g of 4-chlorophenyl acrylate (a refractive index of 1.536), 0.126 g of a photo-polymerization initiator (Irgacure 784, manufactured by Ciba Special Chemicals Co., Ltd.) and 0.0126 g of a sensitizing dye (Dye-1: described above) was added to aforesaid solution 2. Finally, the prepared composition was degassed with nitrogen, and the gas components occluded were eliminated by use of a ultrasonic washer resulting in preparation of holographic recording layer forming composition 3 as a comparative sample.

(Holographic Recording Layer Forming Composition 4 - 14)

Holographic recording layer forming composition 4 - 14 were prepared in a similar manner to holographic recording layer forming composition 1, except that photo-polymerization initiators (C) shown in table 1 were employed instead of the photo-polymerization initiator and the sensitizing dye which were employed in the preparation of holographic recording layer forming composition 1.

(Holographic Recording Layer Forming Composition 15 - 19)

Holographic recording layer forming composition 15 - 19 were prepared in a similar manner to holographic recording layer forming composition 2, except that photo-polymerization initiators (C) shown in table 1 were employed instead of the photo-polymerization initiator and the sensitizing dye which were employed in preparation of holographic recording layer forming composition 2.

Table 1

| | Photo-polymerization Initiator (C) | |
|---|---|---|
| | Type | Addition amount (g) |
| Holographic recording layer forming composition 4 | C-1 | 0.074 |
| Holographic recording layer forming composition 5 | C-1 | 0.110 |

Table 1 (continued)

| | Photo-polymerization Initiator (C) | |
|---|---|---|
| | Type | Addition amount (g) |
| Holographic recording layer forming composition 6 | C-2 | 0.071 |
| Holographic recording layer forming composition 7 | C-3 | 0.083 |
| Holographic recording layer forming composition 8 | C-4 | 0.092 |
| Holographic recording layer forming composition 9 | C-5 | 0.080 |
| Holographic recording layer forming composition 10 | C-8 | 0.091 |
| Holographic recording layer forming composition 11 | C-9 | 0.097 |
| Holographic recording layer forming composition 12 | C-10 | 0.096 |
| Holographic recording layer forming composition 13 | C-11 | 0.090 |
| Holographic recording layer forming composition 14 | C-12 | 0.087 |
| Holographic recording layer forming composition 15 | C-1 | 0.147 |
| Holographic recording layer forming composition 16 | C-2 | 0.141 |
| Holographic recording layer forming composition 17 | C-6 | 0.169 |
| Holographic recording layer forming composition 18 | C-7 | 0.203 |
| Holographic recording layer forming composition 19 | C-12 | 0.173 |

C-1

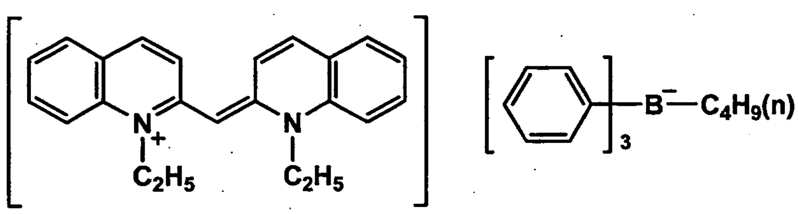

C-2

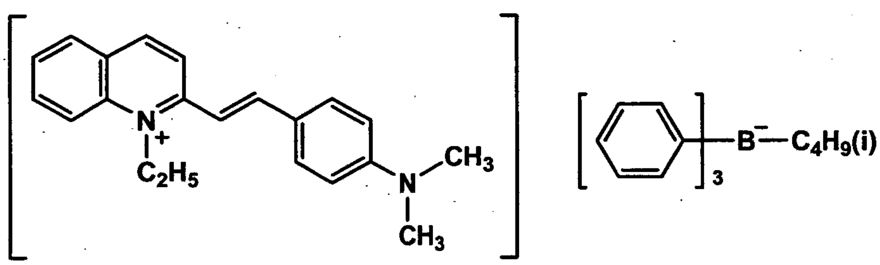

C-3

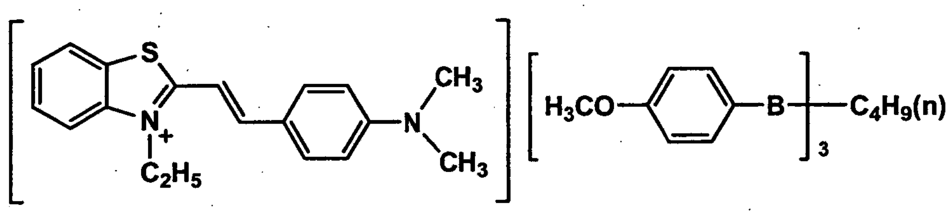

C-4

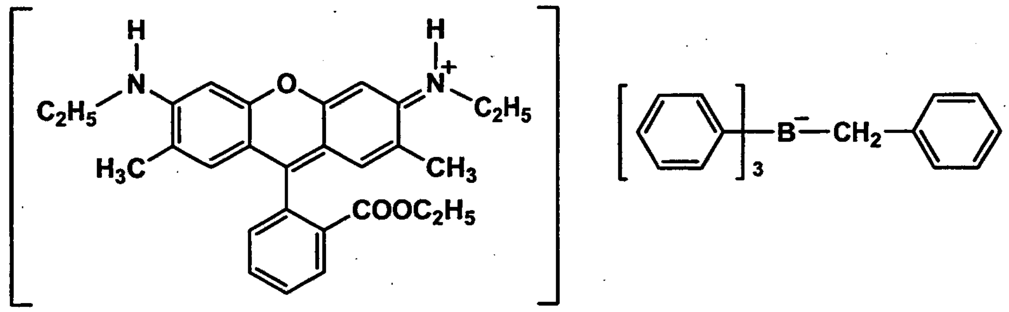

C-5

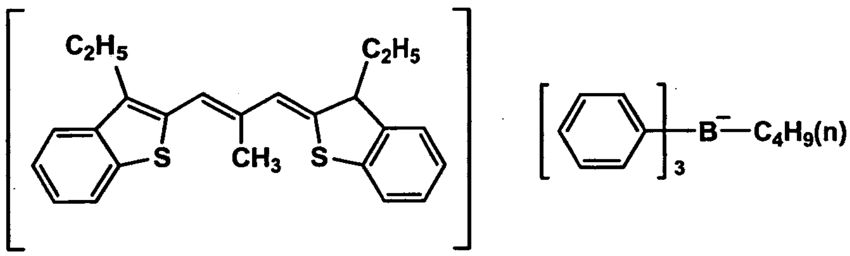

C-6

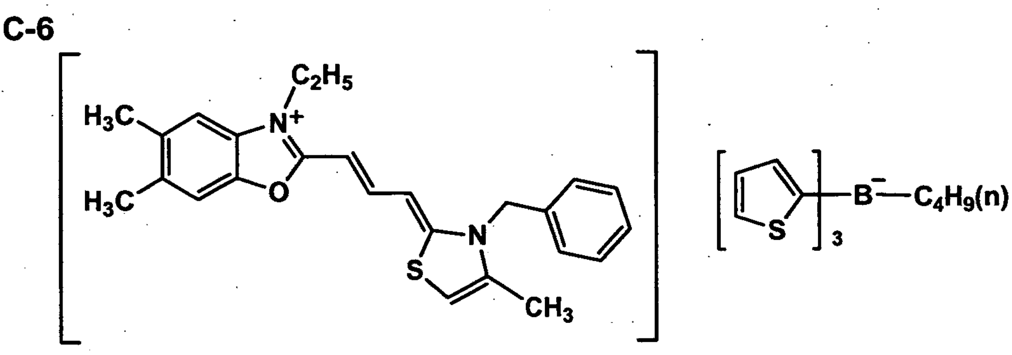

C-7

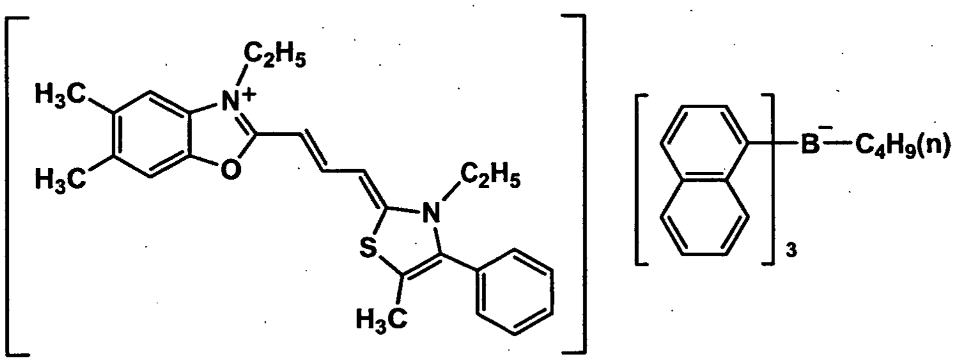

C-8

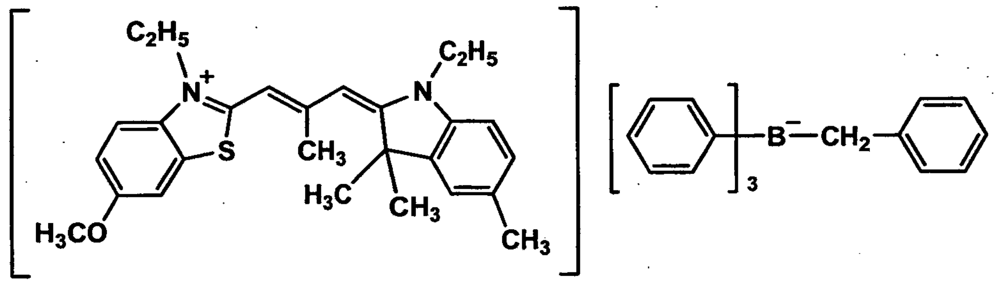

C-9

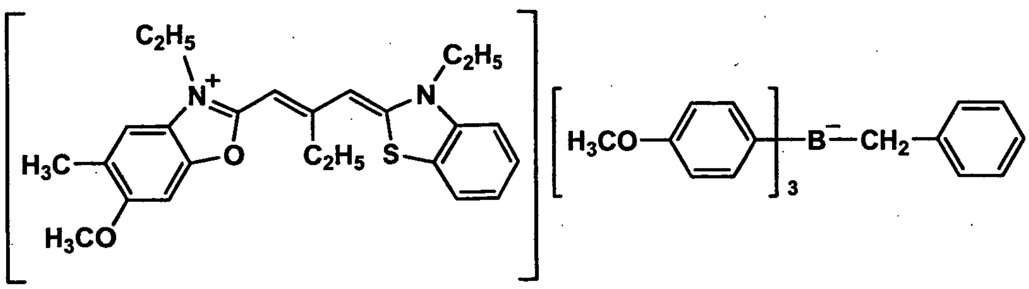

C-10

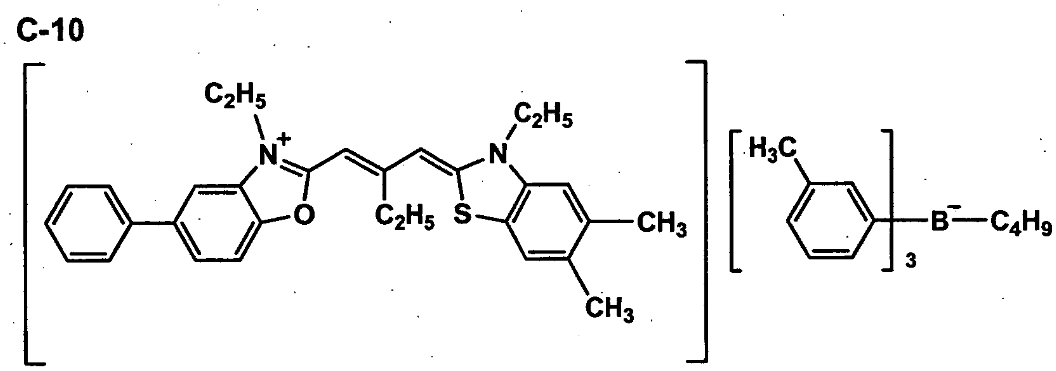

C-11

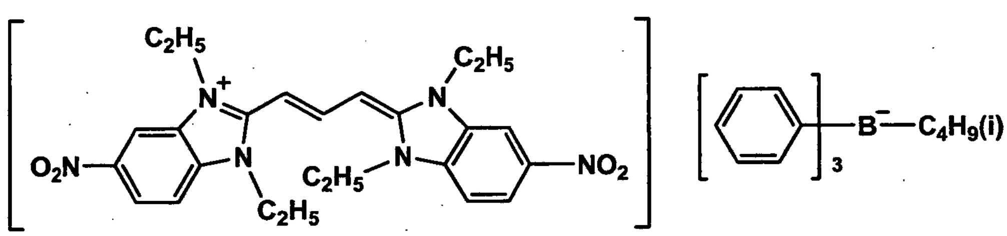

C-12

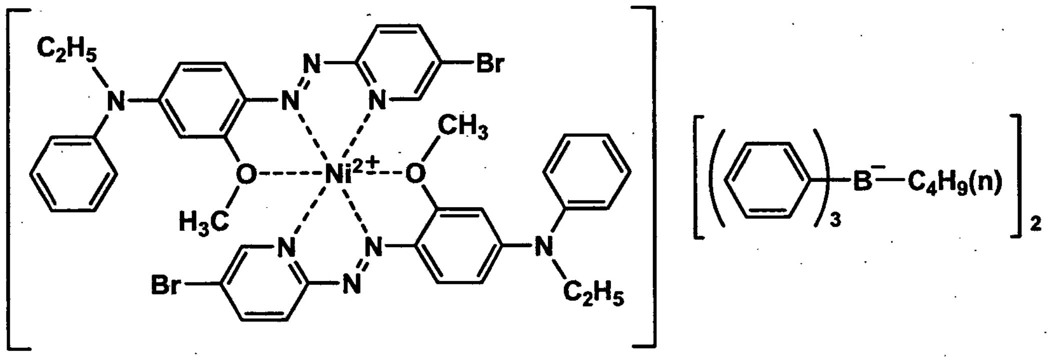

(Holographic Recording Layer Forming Composition 20 -27)

Solution 4 was prepared by mixing 9.697 g of epoxypropoxypropyl-end polydimethyl siloxane (Silaplaine FM-5111, manufactured by Chisso Co., Ltd.), 2.953 g of pentaerythritol (tetrakismercapto propionate) and 0.411 g of 2,4,6-tris(dimethylaminomethyl)phenol. Next, compound (B) having the (meth)acryloyl groups, and photopolymerization initiators (C), shown in table 2, were added and stirred to make a homogeneous solution. Finally, the homogeneous solution was degassed with nitrogen, and the gas components occluded were eliminated by use of a ultrasonic washer resulting in preparation of holographic recording layer forming composition 20 - 27.

Table 2

| | Compound (B) provided with (meth)acryloyl group | | | Photo-polymerization initiator (C) | |
|---|---|---|---|---|---|
| | Type | Refractive index | Addition amount (g) | Type | Addition amount (g) |
| Holographic recording layer forming composition 20 | B-1 | 1.536 | 2.189 | C-4 | 0.182 |
| Holographic recording layer forming composition 21 | B-1/B-2 | 1.536/ 1.546 | 1.532/ 1.060 | C-1 | 0.147 |
| Holographic recording layer forming composition 22 | B-3 | 1.553 | 3.72 | C-1 | 0.147 |
| Holographic recording layer forming composition 23 | B-4 | 1.548 | 3.888 | C-1 | 0.147 |
| Holographic recording layer forming composition 24 | B-4/B-6 | 1.548/1.583 | 1.944/1.452 | C-1 | 0.147 |
| Holographic recording layer forming composition 25 | B-5 | 1.576 | 2.904 | C-4 | 0.182 |
| Holographic recording layer forming composition 26 | B-6 | 1.583 | 2.904 | C-12 | 0.173 |
| Holographic recording layer forming composition 27 | B-1/B-7 | 1.536/ 1.597 | 1.751/ 1.085 | C-4 | 0.182 |

Table 2 (continued)

| | Compound (B) provided with (meth)acryloyl group | | | Photo-polymerization initiator (C) | |
|---|---|---|---|---|---|
| | Type | Refractive index | Addition amount (g) | Type | Addition amount (g) |

B-1: 4-chlorophenyl acrylate
B-2: Bisphenol A EO-modified diacrylate (Aronix M210, manufactured by Toagosei Co., Ltd.)
B-3: Paracumylphenoxy ethyleneglycol methacrylate (NK Ester CMP-1E, manufactured by Shin-Nakamura Chemicals Co., Ltd.)
B-4: Paracumylphenoxy ethyleneglycol acrylate (NK Ester A-CMP-1E, manufactured by Shin-Nakamura Chemicals Co., Ltd.)
B-5: Hydroxyetylated o-phenylphenol acrylate (NK Ester A-L4, manufactured by Shin-Nakamura Chemicals Co., Ltd.)
B-6: Hydroxyetylated β-naphtol acrylate (NK Ester A-NP-1E, manufactured by Shin-Nakamura Chemicals Co., Ltd.)
B-7: 9,9-bis(3-phenyl-4-acryloyl polyoxyethoxy)fluorine

(Holographic Recording Layer Forming Composition 28 -38)

The binder compounds (A) provided with reactive groups shown in table 3, 2.413 g of hydroxyethylated β-naphtholacrylate (NK Ester A-NP-1E, manufactured by Shin-Nakamura Chemicals Co., Ltd.) and 10.201 g of a photo-polymerization initiator were added and stirred to be dissolved to make a homogeneous solution 4. To this solution added were a cross-linking agent (D) provided with a functional group reactive with the reactive groups of the aforesaid binder compound (A) provided with reactive groups described in table 3 and a cross-linking accelerator (E) and stirred to make a homogeneous solution, followed by being degassed with nitrogen, and finally the gas components occluded were eliminated by use of a ultrasonic washer resulting in preparation of holographic recording layer forming composition 28 - 38.

Table 3

| | Binder compound (A) | | Cross-linking agent (D) | | Cross-linking accelerator (E) | |
|---|---|---|---|---|---|---|
| | Type | Addition amount (g) | Type | Addition amount (g) | Type | Addition amount (g) |
| Holographic recording layer forming composition 28 | A-1 | 15.740 | D-4 | 0.393 | E-3 | 0.33 |
| Holographic recording layer forming composition 29 | A-2 | 9.385 | D-1 | 6.354 | E-1 | 0.883 |
| Holographic recording layer forming composition 30 | A-2 | 15.740 | D-4 | 0.472 | E-3 | 0.396 |
| Holographic recording layer forming composition 31 | A-3 | 9.056 | D-2 | 6.683 | - | - |

Table 3 (continued)

| | Binder compound (A) | | Cross-linking agent (D) | | Cross-linking accelerator (E) | |
|---|---|---|---|---|---|---|
| | Type | Addition amount (g) | Type | Addition amount (g) | Type | Addition amount (g) |
| Holographic recording layer forming composition 32 | A-3 | 13.048 | D-3 | 2.691 | E-2 | 0.029 |
| Holographic layer forming composition 33 | A-4 | 13.289 | D-3 | 2.45 | E-2 | 0.026 |
| Holographic recording layer forming composition 34 | A-6 | 15.740 | D-5 | 0.315 | - | - |
| Holographic recording layer forming composition 35 | A-2/ A-5 | 12.592/ 3.148 | D-5 | 0.315 | - | - |
| Holographic recording layer forming composition 36 | A-2/ A-6 | 13.379/ 2.361 | D-5 | 0.315 | E-3 | 0.265 |
| Holographic recording layer forming composition 37 | A-2/ A-7 | 12.592/ 3.148 | D-5 | 0.315 | - | - |
| Holographic recording layer forming composition 38 | A-2/ A-8 | 13.772/ 1.968 | D-5 5 | 0.315 | E-3 | 0.265 |

A-1: Epoxypropoxypropyl-end polydimetylsiloxane (Silaplaine FM-5511, manufactured by Chisso Co., Ltd.) A-2: Epoxypropoxypropyl-end polydimetylsiloxane (DMS-E01, manufactured by Gelest Co., Ltd.) A-3: Aminopropyl-ended polydimethylsiloxane (DMS-A11, manufactured by Gelest Co., Ltd.)

A-4: 4411, Alcohol-modified polydimethylsiloxane (Silaplaine FM-manufactured by Chisso Co., Ltd.)

A-5: 3-etyl-3-(phenoxymethyl) oxetane

A-6: Di[1-ethyl(3-oxetanyl)] methylether

A-7: 3-ethyl-3-(2-ethylhexyloxymethyl) oxetane

Table 3 (continued)

| | Binder compound (A) | | Cross-linking agent (D) | | Cross-linking accelerator (E) | |
|---|---|---|---|---|---|---|
| | Type | Addition amount (g) | Type | Addition amount (g) | Type | Addition amount (g) |

A-8: 1,4-bis{[(3-ethyl-3-oxetanyl)methoxy]methyl} benzene
D-1: Pentaerythritol(tetrakismercapto propionate)
D-2: Bisphenol A PO-modified diglycidylether (Epolight 3002, manufactured by Kyoeisha Chemicals Co., Ltd.)
D-3: 2-isocyanatoethyl-2,6-diisocyanatocaploate (LTI, manufactured by Kyowa Hakko Kogyo Co., Ltd.)
D-4: Sulfonium compound (San-Aid SI-60, manufactured by Sanshin Chemicals Industry Co., Ltd.)
D-5: Sulfonium compound (San-Aid SI-20, manufactured by Sanshin Chemicals Industry Co., Ltd.)
E-1: 2,4,6-tris(dimethylaminomethyl) phenol
E-2: Dibutyl tin dilaurylate
E-3: 1,4-bis(p-toluenesulfonyloxy) cyclohexane

<Preparation of Holographic Recording Media>

(Preparation Method 1)

As the first and second substrates, the one side surface of a glass plate having a thickness of 0.5 mm was subjected to an anti-reflection treatment so as to make a reflectance of 0.1% against the vertical incident light of a wavelength of 532 nm. The holographic recording layer forming compositions described in table 4 were applied on the surface without an anti-reflection treatment of the first substrate, employing a polyethylene terephthalate sheet having the thickness described in table 4 as a spacer, and subsequently the surface without an anti-reflection treatment of the second substrate was laminated onto the holographic recording layer forming composition not as to occlude an air layer to result in lamination of the first and second substrates while sandwiching the spacer. Finally, the edges were sealed with a moisture-curable adhesive and the samples were kept at room temperature for 24 hours to prepare the holographic recording media.

(Preparation Method 2)

The holographic recording media described in tables 4 and 5 were prepared in a similar manner to preparation method 1 by being kept at 45 °C for 24 hours after the edges had been sealed with a moisture-curable adhesive.

(Preparation Method 3)

The first substrate was prepared by subjecting the one side surface of a glass plate having a thickness of 0.5 mm to an anti-reflection treatment so as to make a reflectance of 0.1% against the vertical incident light of a wavelength of 532 nm, and the second substrate was prepared by subjecting the one side surface of a glass plate having a thickness of 0.5 mm to aluminum evaporation so as to make a reflectance of 90% against the vertical incident light of a wavelength of 532 nm. Next, the holographic recording layer forming compositions described in table 6 were applied on the surface without an anti-reflection treatment of the first substrate, employing a polyethylene terephthalate sheet having the thickness described in table 6 as a spacer, and subsequently the surface with aluminum evaporation of the second substrate was laminated onto the holographic recording layer forming composition not as to occlude an air layer to result in lamination of the first and second substrates while sandwiching the spacer. Finally, the edges were sealed with a moisture-curable adhesive and the samples were kept at room temperature for 24 hours to prepare the holographic recording media.

(Preparation Method 4)

The holographic recording media described in tables 6 were prepared in a similar manner to preparation method 3 by being kept at 45 °C for 24 hours after the edges had been sealed with a moisture-curing type adhesive.

Table 4

| Holographic recording medium No. | Holographic recording layer forming No. composition | Preparation method | Thickness (mm) |
|---|---|---|---|
| Recording medium 1 | Composition 2 | Preparation method 1 | 0.20 |
| Recording medium 2 | Composition 2 | Preparation method 1 | 0.50 |
| Recoding medium 3 | Composition 3 | Preparation method 1 | 0.20 |
| Recording medium 4 | Composition 4 | Preparation method 1 | 0.20 |
| Recording medium 5 | Composition 5 | Preparation method 1 | 0.20 |
| Recording medium 6 | Composition 5 | Preparation method 1 | 0.50 |
| Recording medium 7 | Composition 11 | Preparation method 1 | 0.20 |
| Recording medium 8 | Composition 13 | Preparation method 1 | 0.20 |
| Recording medium 9 | Composition 14 | Preparation method 1 | 0.20 |
| Recording medium 10 | Composition 15 | Preparation method 1 | 0.20 |
| Recording medium 11 | Composition 15 | Preparation method 1 | 0.50 |
| Recording medium 12 | Composition 16 | Preparation method 1 | 0.20 |
| Recording medium 13 | Composition 17 | Preparation method 1 | 0.20 |
| Recording medium 14 | Composition 18 | Preparation method 1 | 0.20 |
| Recording medium 15 | Composition 19 | Preparation method 1 | 0.20 |
| Recording medium 16 | Composition 20 | Preparation method 1 | 0.20 |
| Recording medium 17 | Composition 21 | Preparation method 1 | 0.20 |
| Recording medium 18 | Composition 21 | Preparation method 1 | 0.50 |
| Recording medium 19 | Composition 22 | Preparation method 1 | 0.20 |
| Recording medium 20 | Composition 23 | Preparation method 1 | 0.20 |
| Recording medium 21 | Composition 24 | Preparation method 1 | 0.20 |
| Recording medium 22 | Composition 29 | Preparation method 1 | 0.20 |
| Recording medium 23 | Composition 29 | Preparation method 1 | 0.50 |
| Recording medium 24 | Composition 1 | Preparation method 2 | 0.20 |
| Recording medium 25 | Composition 1 | Preparation method 2 | 0.50 |
| Recording medium 26 | Composition 3 | Preparation method 2 | 0.20 |
| Recording medium 27 | Composition 4 | Preparation method 2 | 0.20 |
| Recording medium 28 | Composition 5 | Preparation method 2 | 0.20 |
| Recording medium 29 | Composition 5 | Preparation method 2 | 0.50 |
| Recording medium 30 | Composition 6 | Preparation method 2 | 0.20 |
| Recording medium 31 | Composition 7 | Preparation method 2 | 0.20 |

Table 5

| Holographic recording medium No. | Holographic recording layer forming composition | Preparation method | Thickness (mm) |
|---|---|---|---|
| Recording medium 32 | Composition 8 | Preparation method 2 | 0.20 |
| Recording medium 33 | Composition 9 | Preparation method 2 | 0.20 |

Table 5 (continued)

| Holographic recording medium No. | Holographic recording layer forming composition | Preparation method | Thickness (mm) |
|---|---|---|---|
| Recording medium 34 | Composition 10 | Preparation method 2 | 0.20 |
| Recording medium 35 | Composition 11 | Preparation method 2 | 0.20 |
| Recording medium 36 | Composition 12 | Preparation method 2 | 0.20 |
| Recording medium 37 | Composition 13 | Preparation method 2 | 0.20 |
| Recording medium 38 | Composition 14 | Preparation method 2 | 0.20 |
| Recording medium 39 | Composition 20 | Preparation method 2 | 0.20 |
| Recording medium 40 | Composition 21 | Preparation method 2 | 0.20 |
| Recording medium 41 | Composition 21 | Preparation method 2 | 0.50 |
| Recording medium 42 | Composition 25 | Preparation method 2 | 0.20 |
| Recording Recording | Composition 26 | Preparation method 2 | 0.20 |
| Recording medium 44 | Composition 27 | Preparation method 2 | 0.20 |
| Recording medium 45 | Composition 27 | Preparation method 2 | 0.50 |
| Recording medium 46 | Composition 29 | Preparation method 2 | 0.20 |
| Recording medium 47 | Composition 29 | Preparation method 2 | 0.50 |
| Recording medium 48 | Composition 32 | Preparation method 2 | 0.20 |
| Recording medium 49 | Composition 33 | Preparation method 2 | 0.20 |
| Recording medium 50 | Composition 34 | Preparation method 2 | 0.20 |
| Recording medium 51 | Composition 35 | Preparation method 2 | 0.20 |
| Recording medium 52 | Composition 36 | Preparation method 2 | 0.20 |
| Recording medium 53 | Composition 36 | Preparation method 2 | 0.50 |
| Recording medium 54 | Composition 37 | Preparation method 2 | 0.20 |
| Recording medium 55 | Composition 38 | Preparation method 2 | 0.20 |

Table 6

| Holographic recording medium No. | Holographic recording layer forming composition No. | Preparation method | Thickness (mm) |
|---|---|---|---|
| Recording medium 56 | Composition 2 | Preparation method 3 | 0.20 |
| Recording medium 57 | Composition 2 | Preparation method 3 | 0.50 |
| Recording medium 58 | Composition 3 | Preparation method 3 | 0.20 |
| Recording medium 59 | Composition 3 | Preparation method 3 | 0.20 |
| Recording medium 60 | Composition 15 | Preparation method 3 | 0.20 |
| Recording medium 61 | Composition 16 | Preparation method 3 | 0.20 |
| Recording medium 62 | Composition 17 | Preparation method 3 | 0.20 |
| Recording medium 63 | Composition 18 | Preparation method 3 | 0.20 |
| Recording medium 64 | Composition 19 | Preparation method 3 | 0.20 |
| Recording medium 65 | Composition 20 | Preparation method 3 | 0.20 |
| Recording medium 66 | Composition 21 | Preparation method 3 | 0.20 |

Table 6 (continued)

| Holographic recording medium No. | Holographic recording layer forming composition No. | Preparation method | Thickness (mm) |
|---|---|---|---|
| Recording medium 67 | Composition 22 | Preparation method 3 | 0.20 |
| Recording medium 68 | Composition 23 | Preparation method 3 | 0.20 |
| Recording medium 69 | Composition 24 | Preparation method 3 | 0.20 |
| Recording medium 70 | Composition 25 | Preparation method 3 | 0.20 |
| Recording medium 71 | Composition 27 | Preparation method 3 | 0.20 |
| Recording medium 72 | Composition 27 | Preparation method 3 | 0.50 |
| Recording medium 73 | Composition 29 | Preparation method 3 | 0.20 |
| Recording medium 74 | Composition 1 | Preparation method 4 | 0.20 |
| Recording medium 75 | Composition 1 | Preparation method 4 | 0.20 |
| Recording medium 76 | Composition 3 | Preparation method 4 | 0.20 |
| Recording medium 77 | Composition 3 | Preparation method 4 | 0.20 |
| Recording medium 78 | Composition 8 | Preparation method 4 | 0.20 |
| Recording medium 79 | Composition 20 | Preparation method 4 | 0.20 |
| Recording medium 80 | Composition 20 | Preparation method 4 | 0.50 |
| Recording medium 81 | Composition 22 | Preparation method 4 | 0.20 |
| Recording medium 82 | Composition 23 | Preparation method 4 | 0.20 |
| Recording medium 83 | Composition 25 | Preparation method 4 | 0.20 |
| Recording medium 84 | Composition 27 | Preparation method 4 | 0.20 |
| Recording medium 85 | Composition 27 | Preparation method 4 | 0.50 |
| Recording medium 86 | Composition 28 | Preparation method 4 | 0.50 |
| Recording medium 87 | Composition 30 | Preparation method 4 | 0.20 |
| Recording medium 88 | Composition 31 | Preparation method 4 | 0.20 |
| Recording medium 89 | Composition 34 | Preparation method 4 | 0.20 |
| Recording medium 90 | Composition 35 | Preparation method 4 | 0.20 |
| Recording medium 91 | Composition 36 | Preparation method 4 | 0.20 |
| Recording medium 92 | Composition 36 | Preparation method 4 | 0.50 |
| Recording medium 93 | Composition 37 | Preparation method 4 | 0.20 |
| Recording medium 94 | Composition 38 | Preparation method 4 | 0.20 |

<Recording on Holographic Recording Media and Evaluation>

(Recording on Holographic Recording Media and Evaluation 1)

Holographic recording media prepared above, on which series of multiple hologram has been written according to the procedure described in USP No. 5,719,691, were measured and evaluated with respect to sensitivity (recording energy) and a refractive index contrast according to the following methods, and the results obtained are shown in tables 7 and 8.

(Measurement of Sensitivity)

Under safe light, holographic recording media were holographic exposed at an energy of 0.1 - 50 $mJ/cm^2$

according to the digital pattern which was displayed by a holography producing apparatus equipped with a Nd:YAG laser (532 nm) which results in formation of holograms. Next, employing laser (532 nm) as the reference light, the generated Nd:YAG reproducing light was read out with CCD, and the minimum exposure amount to reproduce a satisfactory digital pattern was designated as a sensitivity (S).

(Evaluation of Refractive Index Contrast)

The refractive index contrast was determined from the diffraction efficiency measured according to the following method. To measure the diffraction efficiency, a photomultiplier, which employs ART 25 Spectrometer produced by Nippon Bunko Kogyo Co., Ltd. and has a slit of 3 mm wide, was arranged on the circumference having a radius of 20 cm with the sample at the center. Monochromatic light of 0.3 mm wide was incident at an angle of 45 degrees against the sample, and the diffraction light from the sample was detected. The ratio of the maximum value other than the right reflective light to the value when directly accepting the incident light without placing a sample is defined as a diffraction efficiency, and the refractive index contrast (Δn) was determined from the obtained diffraction efficiency of a hologram.

Table 7

| | Holographic recording medium No. | S ($mJ/cm^2$) | Δn (x $10^{-3}$). |
|---|---|---|---|
| Comparative 1-1 | Recording medium 1 | 20 | 1.7 |
| Comparative 1-2 | Recording medium 2 | 30 | 2.5 |
| Comparative 1-3 | Recording medium 3 | 18 | 2.2 |
| Invention 1-1 | Recording medium 4 | 1.5 | 3.8 |
| Invention 1-2 | Recording medium 5 | 1.3 | 3.7 |
| Invention 1-3 | Recording medium 6 | 1.5 | 4.5 |
| Invention 1-4 | Recording medium 7 | 1.3 | 3.7 |
| Invention 1-5 | Recording medium 8 | 1.5 | 3.9 |
| Invention 1-6 | Recording medium 9 | 2.5 | 4.2 |
| Invention 1-7 | Recording medium 10 | 1.1 | 4.1 |
| Invention 1-8 | Recording medium 11 | 1.4 | 4.9 |
| Invention 1-9 | Recording medium 12 | 1.2 | 4.2 |
| Invention 1-10 | Recording medium 13 | 1.2 | 4.2 |
| Invention 1-11 | Recording medium 14 | 1.1 | 4.3 |
| Invention 1-12 | Recording medium 15 | 1.6 | 4.2 |
| Comparative 1-4 | Recording medium 24 | 15 | 2.3 |
| Comparative 1-5 | Recording medium 25 | 20 | 2.6 |
| Comparative 1-6 | Recording medium 26 | 20 | 2.5 |
| Invention 1-13 | Recording medium 27 | 1.7 | 4.1 |
| Invention 1-14 | Recording medium 28 | 1.5 | 4.2 |
| Invention 1-15 | Recording medium 29 | 1.7 | 4.7 |
| Invention 1-16 | Recording medium 30 | 1.5 | 4.3 |
| Invention 1-17 | Recording medium 31 | 1.6 | 4.4 |
| Invention 1-18 | Recording medium 32 | 1.5 | 4.2 |
| Invention 1-19 | Recording medium 33 | 1.5 | 4.4 |

Table 8

| | Holographic recording medium No. | S ($mJ/cm^2$) | Δn (x $10^{-3}$) |
|---|---|---|---|
| Invention 1-20 | Recording medium 34 | 1.4 | 4.3 |
| Invention 1-21 | Recording medium 35 | 1.6 | 4.5 |
| Invention 1-22 | Recording medium 36 | 1.5 | 4.2 |
| Invention 1-23 | Recording medium 37 | 1.6 | 4.5 |
| Invention 1-24 | Recording medium 38 | 2.8 | 5.2 |
| Invention 1-25 | Recording medium 39 | 1.1 | 5.3 |
| Invention 1-26 | Recording medium 40 | 1.4 | 5.5 |
| Invention 1-27 | Recording medium 41 | 2.6 | 6.8 |
| Invention 1-28 | Recording medium 42 | 1.7 | 7.2 |
| Invention 1-29 | Recording medium 43 | 2.7 | 7.5 |
| Invention 1-30 | Recording medium 44 | 1.5 | 7.8 |
| Invention 1-31 | Recording medium 45 | 2.5 | 8.9 |
| Invention 1-32 | Recording medium 46 | 1.8 | 7.6 |
| Invention 1-33 | Recording medium 47 | 2.6 | 9.2 |
| Invention 1-34 | Recording medium 48 | 1.3 | 8.9 |
| Invention 1-35 | Recording medium 49 | 1.4 | 8.8 |
| Invention 1-36 | Recording medium 50 | 1.2 | 8.4 |
| Invention 1-37 | Recording medium 51 | 1.3 | 8.4 |
| Invention 1-38 | Recording medium 52 | 1.2 | 8.5 |
| Invention 1-39 | Recording medium 53 | 1.6 | 9.1 |
| Invention 1-40 | Recording medium 54 | 1.1 | 8.7 |
| Invention 1-41 | Recording medium 55 | 1.3 | 8.6 |

It is clear that recording media of this invention are provided with a higher sensitivity and a higher contrast compared to comparative examples.

(Recording on Holographic Recording Media and Evaluation 2)

Holographic recording media prepared above, on which series of multiple hologram has been written according to the procedure described in USP No. 5,719,691, were measured and evaluated with respect to sensitivity (recording energy) and the aforesaid refractive index contrast according to the following methods, and the results obtained are shown in table 9.

(Measurement of Sensitivity)

Under safe light, holographic recording media were holographic exposed at an energy of 0.1 - 50 $mJ/cm^2$ according to the digital pattern which was displayed by a holography producing apparatus equipped with a Nd:YAG laser (532 nm) which resulted in formation of holograms. Next, the holographic recording media were exposed under a sunshine fade meter of 70,000 lux for 5 minutes. Under safe light and employing Nd:YAG laser (532 nm) as the reference light, the generated reproducing light of the recording media thus treated was read out with CCD, and the minimum exposure amount to reproduce a satisfactory digital pattern was designated as a sensitivity (S).

Table 9

| | Holographic recording medium No. | S ($mJ/cm^2$) | $\Delta n$ (x $10^{-3}$) |
|---|---|---|---|
| Comparative 2-1 | Recording medium 1 | 25 | 1.9 |
| Comparative 2-2 | Recording medium 2 | 35 | 2.8 |
| Comparative 2-3 | Recording medium 3 | 20 | 2.5 |
| Invention 2-1 | Recording medium 4 | 1.6 | 4.1 |
| Invention 2-2 | Recording medium 5 | 1.3 | 3.9 |
| Invention 2-3 | Recording medium 6 | 1.7 | 4.7 |
| Invention 2-4 | Recording medium 7 | 1.4 | 3.9 |
| Invention 2-5 | Recording medium 8 | 1.5 | 4.0 |
| Invention 2-6 | Recording medium 9 | 2.6 | 4.3 |
| Invention 2-7 | Recording medium 10 | 1.3 | 4.3 |
| Invention 2-8 | Recording medium 11 | 1.6 | 5.2 |
| Invention 2-9 | Recording medium 12 | 1.3 | 4.4 |
| Invention 2-10 | Recording medium 13 | 1.2 | 4.3 |
| Invention 2-11 | Recording medium 14 | 1.2 | 4.5 |
| Invention 2-12 | Recording medium 15 | 1.6 | 4.4 |
| Invention 2-13 | Recording medium 16 | 1.2 | 5.2 |
| Invention 2-14 | Recording medium 17 | 1.5 | 5.2 |
| Invention 2-15 | Recording medium 18 | 2.6 | 6.5 |
| Invention 2-16 | Recording medium 19 | 1.5 | 6.9 |
| Invention 2-17 | Recording medium 20 | 1.4 | 7.2 |
| Invention 2-18 | Recording medium 21 | 1.6 | 7.4 |
| Invention 2-19 | Recording medium 22 | 1.9 | 7.4 |
| Invention 2-20 | Recording medium 23 | 2.6 | 8.9 |
| Invention 2-21 | Recording medium 42 | 1.8 | 7.5 |
| Invention 2-22 | Recording medium 43 | 2.8 | 7.8 |
| Invention 2-23 | Recording medium 44 | 1.5 | 8.2 |
| Invention 2-24 | Recording medium 45 | 2.6 | 9.3 |
| Invention 2-25 | Recording medium 50 | 1.2 | 8.6 |
| Invention 2-26 | Recording medium 51 | 1.3 | 8.7 |
| Invention 2-27 | Recording medium 52 | 1.3 | 8.8 |
| Invention 2-28 | Recording medium 53 | 1.9 | 9.6 |
| Invention 2-29 | Recording medium 54 | 1.2 | 9.1 |
| Invention 2-30 | Recording medium 55 | 1.3 | 8.9 |

It is also clear that recording media of this invention are provided with a higher sensitivity and a higher contrast compared to comparative examples.

(Recording on Holographic Recording Media and Evaluation 3)

Holographic recording media prepared above, on which series of multiple hologram have been written according to the procedure described in JP-A No. 2002-123949, were measured and evaluated with respect to sensitivity (recording energy) and the aforesaid refractive index contrast according to the following methods, and the results obtained are shown in table 10.

(Measurement of Sensitivity)

Under safe light, holographic recording media were holographic exposed at an energy of 0.1 - 50 mJ/cm$^2$ according to the digital pattern which was displayed by a holography producing apparatus equipped with a Nd:YAG laser (532 nm), which resulted in formation of holograms. Next, the holographic recording media were exposed under a sunshine fade meter of 70,000 lux for 5 minutes. Under safe light and employing Nd:YAG laser (532 nm) as the reference light, the generated reproducing light of the recording media thus treated was read out with CCD, and the minimum exposure amount to reproduce a satisfactory digital pattern was designated as a sensitivity (S).

Table 10

| | Holographic recording medium No. | S (mJ/cm$^2$) |
|---|---|---|
| Comparison 3-1 | Recording medium 56 | 18 |
| Comparison 3-2 | Recording medium 57 | 26 |
| Comparison 3-3 | Recording medium 58 | 15 |
| Comparison 3-4 | Recording medium 59 | 20 |
| Invention 3-1 | Recording medium 60 | 1 |
| Invention 3-2 | Recording medium 61 | 1.1 |
| Invention 3-3 | Recording medium 62 | 1.1 |
| Invention 3-4 | Recording medium 63 | 1.1 |
| Invention 3-5 | Recording medium 64 | 1.5 |
| Invention 3-6 | Recording medium 65 | 1 |
| Invention 3-7 | Recording medium 66 | 1.2 |
| Invention 3-8 | Recording medium 67 | 1.3 |
| Invention 3-9 | Recording medium 68 | 1.2 |
| Invention 3-10 | Recording medium 69 | 1.3 |
| Invention 3-11 | Recording medium 70 | 1.4 |
| Invention 3-12 | Recording medium 71 | 1.4 |
| Invention 3-13 | Recording medium 72 | 1.9 |
| Invention 3-14 | Recording medium 73 | 1.5 |
| Comparison 3-5 | Recording medium 74 | 12 |
| Comparison 3-6 | Recordinq medium 75 | 15 |
| Comparison 3-7 | Recording medium 76 | 18 |
| Comparison 3-8 | Recording medium 77 | 25 |
| Invention 3-15 | Recording medium 78 | 1.3 |
| Invention 3-16 | Recording medium 79 | 1 |
| Invention 3-17 | Recording medium 80 | 1.5 |
| Invention 3-18 | Recording medium 81 | 1.6 |
| Invention 3-19 | Recording medium 82 | 1.5 |
| Invention 3-20 | Recording medium 83 | 1.6 |
| Invention 3-21 | Recording medium 84 | 1.3 |

Table 10 (continued)

| | Holographic recording medium No. | S ($mJ/cm^2$) |
|---|---|---|
| Invention 3-22 | Recording medium 85 | 2.2 |
| Invention 3-23 | Recording medium 86 | 1.4 |
| Invention 3-24 | Recording medium 87 | 1.5 |
| Invention 3-25 | Recording medium 88 | 1.5 |
| Invention 3-26 | Recording medium 89 | 1.1 |
| Invention 3-27 | Recording medium 90 | 1.2 |
| Invention 3-28 | Recording medium 91 | 1.1 |
| Invention 3-29 | Recording medium 92 | 1.4 |
| Invention 3-30 | Recording medium 93 | 1 |
| Invention 3-31 | Recording medium 94 | 1.3 |

It is clear that the recording media of this invention exhibit a higher sensitivity compared to the comparative examples.

[EFFECTS OF THE INVENTION]

This invention can provide holographic recording media having a high sensitivity as well as a high contrast, and a holographic recording method utilizing them.

## Claims

**1.** A holographic recording medium comprising a first substrate and a second substrate having a holographic recording layer between the first substrate and the second substrate, the holographic recording layer containing:

(A) a binder compound having a reactive group;
(B) a polymerizable compound having an ethylenic double bond;
(C) a photoinitiator; and
(D) a cross-linking agent which reacts with the reactive group in the binder compound,

wherein the photoinitiator contains a compound represented by Formula (1):

Formula (1)

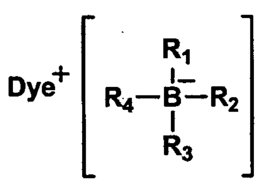

wherein $Dye^+$ is a cationic dye, each $R^1$ to $R^4$ is independently a substituted or unsubstituted alkyl, aryl, aralkyl, alkenyl, alkynyl, heterocylic group, or a cyano group, provided that two or more of $R^1$ to $R^4$ can form a ring.

**2.** The holographic recording medium of claim 1, wherein at least one of $R^1$ to $R^4$ in Formula (1) is a substituted or unsubstituted alkyl, aralkyl, alkenyl or alkynyl group; and at least one of $R^1$ to $R^4$ is a substituted or unsubstituted aryl or heterocyclic group.

**3.** The holographic recording medium of claim 1, wherein $Dye^+$ in Formula (1) is a dye selected from the group

consisting of methine dyes, polymethine dyes, triarylmethane dyes, indoline dyes, azine dyes, thiazine dyes, xanthene dyes, oxazine dyes, acridine dyes, cyanine dyes, carbocyanine dyes, hemicyanine dyes, rhodacyanine dyes, azomethine dyes, styryl dyes, pyrylium dyes, thiopyrylium dyes and metal complex compounds represented by Formula (2):

$$\text{Formula (2) } M^{n+} (L)_x$$

wherein M is a metal atom, n is an integer of 1 to 4, L is a ligand and x is an integer of 1 to 6.

**4.** The holographic recording medium of claim 3, wherein L in Formula (2) is a dye capable of coordinating with M, provided that a coordination number of L with M is 2 or more.

**5.** The holographic recording medium of claim 1, wherein the cross-linking agent contains a siloxane bond or a fluorine-carbon bond in the molecule.

**6.** The holographic recording medium of claim 1, wherein the reactive group in the binder compound is selected from the group consisting of a hydroxy, mercapto, carboxyl, amino, epoxy, oxetane, isocyanate, carbodiimide, oxadiazine, and metal alkoxide group.

**7.** The holographic recording medium of claim 5, wherein the binder compound is a liquid at 20 °C or has a melting point of not more than 50 °C.

**8.** The holographic recording medium of claim 1, wherein the polymerizable compound contains an acryloyl or methacryloyl group in the molecule.

**9.** The holographic recording medium of claim 1, wherein the polymerizable compound has a refractive index of not less than 1.55.

**10.** The holographic recording medium of claim 1, wherein a thickness of the first substrate (d1), a thickness of the second substrate (d2) and a thickness of the holographic recording layer (Dh) satisfy the following formula:

$$0.15 \leq Dh/(d1 + d2) \leq 2.0$$

**11.** The holographic recording medium of claim 10, wherein the thickness of the holographic recording layer (Dh) is 200 μm to 2.0 mm.

**12.** The holographic recording medium of claim 10, wherein the thickness of the first substrate (d1) and the thickness of the second substrate (d2) satisfy the following formula:

$$d1 \leq d2$$

**13.** The holographic recording medium of claim 1, wherein the first substrate is transparent and has an antireflective outer surface and an inner surface, the antireflective outer surface being opposite to the inner surface and the inner surface facing the holographic recording layer.

**14.** The holographic recording medium of claim 1, wherein the first substrate is a glass plate.

**15.** The holographic recording medium of claim 1, wherein an inner surface or an outer surface of the second substrate is coated with a reflective layer having a reflective index of not less than 70%, the inner surface being a surface which has the holographic recording layer thereon.

**16.** The holographic recording medium of claim 1, wherein a shape of the holographic recording medium is a disc form.

**17.** The holographic recording medium of claim 1, wherein a shape of the holographic recording medium is a card form.

**18.** A method of forming a holographic image using a holographic recording medium comprising a first substrate and a second substrate having a holographic recording layer between the two substrate, the holographic recording layer containing:

(A) a binder compound having a reactive group;
(B) a polymerizable compound having an ethylenic double bond;
(C) a photoinitiator;
(D) a cross-linking agent which reacts with the reactive group in the binder compound,

wherein the photoinitiator contains a compound represented by Formula (1):

Formula (1)

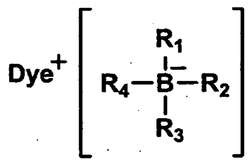

wherein $Dye^+$ is a cationic dye, each $R^1$ to $R^4$ is independently a substituted or unsubstituted alkyl, aryl, aralkyl; alkenyl, alkynyl, heterocylic group, or a cyano group, provided that two or more of $R^1$ to $R^4$ can form a ring, the method comprising the steps of:

(i) irradiating the holographic recording medium with a first light so as to cross-link the binder compound and the cross-linking agent, provided that the first light has not a property of activating the photoinitiator;
(ii) irradiating the holographic recording medium with a second light based on information to be recorded so as to activate the photoinitiator;
(iii) polymerizing the activated photoinitiator with the polymerizable compound(B) to form the holographic image.

**19.** The holographic image forming method of claim 18, comprising further the step of:

(iv) irradiating the holographic recording medium with a light or subjecting the holographic recording medium so as to stabilize the holographic image after completion of the step (iii).

**20.** A method of forming a holographic image using a holographic recording medium comprising a first substrate and a second substrate having a holographic recording layer between the two substrate, the holographic recording layer containing:

(A) a binder compound having a reactive group;
(B) a polymerizable compound having an ethylenic double bond;
(C) a photoinitiator;
(D) a cross-linking agent which reacts with the reactive group in the binder compound,

wherein the photoinitiator contains a compound represented by Formula (1):

Formula (1)

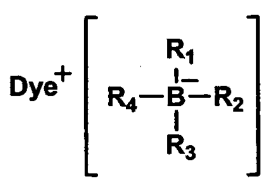

wherein $Dye^+$ is a cationic dye, each $R^1$ to $R^4$ is independently a substituted or unsubstituted alkyl, aryl, aralkyl, alkenyl, alkynyl, heterocylic group, or a cyano group, provided that two or more of $R^1$ to $R^4$ can form a ring, the method comprising the steps of:

(i) irradiating the holographic recording medium with a light based on information to be recorded so as to activate the photoinitiator;
(ii) polymerizing the activated photoinitiator with the polymerizable compound to form the holographic image; and
(iii) irradiating the holographic recording medium with a light or subjecting the holographic recording medium so as to stabilize the holographic image after completion of the step (ii).

**INTERNATIONAL SEARCH REPORT**

International application No.
PCT/JP2004/003684

A. CLASSIFICATION OF SUBJECT MATTER
Int.Cl[7] G03H1/02, G03H1/04, G03F7/004

According to International Patent Classification (IPC) or to both national classification and IPC

B. FIELDS SEARCHED

Minimum documentation searched (classification system followed by classification symbols)
Int.Cl[7] G03H1/02, G03H1/04, G03F7/004

Documentation searched other than minimum documentation to the extent that such documents are included in the fields searched

| | | | |
|---|---|---|---|
| Jitsuyo Shinan Koho | 1926-1996 | Toroku Jitsuyo Shinan Koho | 1994-2004 |
| Kokai Jitsuyo Shinan Koho | 1971-2004 | Jitsuyo Shinan Toroku Koho | 1996-2004 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 8-220975 A (Toyo Ink Manufacturing Co., Ltd.), 30 August, 1996 (30.08.96), Full text; all drawings; particularly, Claims 1 to 3; Par. Nos. [0020], [0025] (Family: none) | 1-3,5-17,20<br>4,18-19 |
| Y | JP 2-11607 A (The Mead Corp.), 16 January, 1990 (16.01.90), Full text; all drawings; particularly, Claims; page 5, lower right column, lines 5 to 15; page 18, lower left column, line 18 to lower right column, line 16<br>& EP 339841 A & EP 339841 B1<br>& US 4937159 A & US 4977511 A<br>& US 5151520 A & DE 68923318 E | 1-4,18-20 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>04 June, 2004 (04.06.04) | Date of mailing of the international search report<br>22 June, 2004 (22.06.04) |
| Name and mailing address of the ISA/<br>Japanese Patent Office<br>Facsimile No. | Authorized officer<br>Telephone No. |

Form PCT/ISA/210 (second sheet) (January 2004)

**INTERNATIONAL SEARCH REPORT**

International application No.
PCT/JP2004/003684

C (Continuation). DOCUMENTS CONSIDERED TO BE RELEVANT

| Category* | Citation of document, with indication, where appropriate, of the relevant passages | Relevant to claim No. |
|---|---|---|
| Y | JP 11-352303 A (Lucent Technologies Inc.), 24 December, 1999 (24.12.99), Full text; all drawings; particularly, Claims 1 to 2, 7 to 8, 12 to 13, 18 & EP 945762 A1 & US 6103454 A & US 6482551 B1 & KR 99078200 A & KR 343202 B | 1-20 |
| Y | JP 8-101501 A (Nippon Paint Co., Ltd.), 16 April, 1996 (16.04.96), Full text; all drawings; particularly, Claim 1; Par. Nos. [0046] to [0047] (Family: none) | 1-20 |
| Y | JP 2003-66816 A (Dainippon Printing Co., Ltd.), 05 March, 2003 (05.03.03), Full text; all drawings; particularly, Claim 1 (Family: none) | 1-20 |
| Y | JP 2002-123949 A (Optware Corp.), 26 April, 2002 (26.04.02), Full text; all drawings & WO 02/15176 A1 & EP 1324322 A1 & US 2004/0042374 A1 & AU 200167866 A & KR 2003019950 A & CN 1446355 A | 15-16 |
| Y | JP 2002-513981 A (OPTILINK AB), 14 May, 2002 (14.05.02), Full text; all drawings & WO 99/57719 A1 & EP 1080466 A1 & EP 1080466 B1 & DE 6920916049 E & AU 9938402 A & CN 1308761 A & KR 2001071211 A | 15,17 |

Form PCT/ISA/210 (continuation of second sheet) (January 2004)